# EUROPEAN PATENT APPLICATION

(11) **EP 4 730 956 A1**
(43) Date of publication of application: **22.04.2026**
(21) Application number: 25205399.6
(22) Date of filing: 29.09.2025
(51) Int. Cl.: H10D 30/67, H10D 86/40

(54) **THIN FILM TRANSISTOR, METHOD FOR MANUFACTURING THE SAME, THIN FILM TRANSISTOR SUBSTRATE, AND DISPLAY APPARATUS**

(30) Priority: 16.10.2024 KR 20240141191
(71) Applicant: LG Display Co., Ltd., Seoul, 07336 (KR)
(72) Inventor: KIM, Sunggu, 10845 Gyeonggi-do (KR); KIM, Hyunki, 10845 Gyeonggi-do (KR); LEE, Chaewoon, 10845 Gyeonggi-do (KR)
(74) Representative: Morrall, Jonathan Ian McLachlan

(57) **Abstract**

The present invention relates to a display apparatus and a method for manufacturing the same. An embodiment of the present invention seek to provide a display apparatus comprising: an active layer; a gate electrode disposed on the active layer and overlapping the active layer; an interlayer insulating film on the gate electrode; and a hydrogen-capture layer on the interlayer insulating film, wherein the interlayer insulating film includes a flat surface parallel to an upper surface of the gate electrode and a first inclined surface disposed on one side of the flat surface and having a constant slope with respect to the flat surface, and the hydrogen-capture layer includes a first hydrogen-capture layer disposed on the flat surface and a second hydrogen-capture layer disposed on the first inclined surface, and the first hydrogen-capture layer and the second hydrogen-capture layer have different crystal structures.

## Description

### CROSS-REFERENCE TO RELATED APPLICATIONS

This application claims the benefit of priority of the Korean Patent Application No. 10-2024-0141191 filed on October 16, 2024, which is hereby incorporated by reference as if fully set forth herein.

### FIELD

The present disclosure relates to a thin film transistor, a method for man ufacturing the same, a thin film transistor substrate including the same, and a display ap paratus including the same.

### BACKGROUND

Transistors are widely used as switching devices or driving devices in the field of electronic devices. In particular, thin film transistors are widely used as switching devices in display devices such as liquid crystal display devices or organic light emitting devices because they can be manufactured on glass or plastic substrates.

Thin film transistors can be classified into amorphous silicon thin film transistors in which amorphous silicon is used as the active layer, polycrystalline silicon thin film transistors in which polycrystalline silicon is used as the active layer, and oxide semiconductor thin film transistors in which oxide semiconductor is used as the active layer, based on the material constituting the active layer.

Recently, as products become more sophisticated, the amount of hydrogen flowing into thin film transistors is increasing due to factors such as an increase in the thickness of the upper silicon nitride film. In addition, when other thin film transistors are disposed around a thin film transistor, hydrogen may flow in from multiple insulating layers, or when a hole is formed in a display area and an electronic device is disposed under the hole in an active area (HiAA) structure, thick insulating layers are stacked in the HiAA region, causing hydrogen to flow in from the insulating layers and resulting in problems.

If hydrogen flows into a thin film transistor, the operating stability of the thin film transistor may deteriorate. Therefore, technologies for suppressing hydrogen flowing in from the top are continuously being studied.

### SUMMARY

One example of the present disclosure can provide a thin film transistor that suppresses hydrogen flowing in from the top by forming a hydrogen capture layer on the top of an active layer.

Another example of the present disclosure can provide a thin film transistor with improved HCS (Hot Carrier Stress) reliability by controlling the crystallinity of a hydrogen capture layer.

Another example of the present disclosure can provide a thin film transistor substrate in which the characteristics of a driving transistor and a switching transistor are simultaneously improved.

Another example of the present disclosure can provide a display apparatus including such a thin film transistor.

In order to achieve the above-described technical problem, one example of the present disclosure provides a thin film transistor including: an active layer; a gate electrode disposed on the active layer and overlapping the active layer; an interlayer insulating film on the gate electrode; and a hydrogen-capture layer on the interlayer insulating film, wherein the interlayer insulating film includes a flat surface parallel to an upper surface of the gate electrode and a first inclined surface disposed on one side of the flat surface and having a constant slope with respect to the flat surface, and the hydrogen-capture layer includes a first hydrogen-capture layer disposed on the flat surface and a second hydrogen-capture layer disposed on the first inclined surface, and the first hydrogen-capture layer and the second hydrogen-capture layer have different crystal structures.

The first hydrogen capture layer may have first crystal grain having a particle size of 1 nm or greater, and the first crystal grain may account for 80% or greater of the total cross-sectional area of the first hydrogen capture layer, and the second hydrogen capture layer may have second crystal grain having a particle size of 1 nm or greater, and the second crystal grain may account for 70% or less of the total cross-sectional area of the second hydrogen capture layer.

The hydrogen capture layer of the thin film transistor is made of an oxide semiconductor material, and the oxide semiconductor material may include at least one of an IZO (InZnO)-based oxide semiconductor material having an In concentration of 50% or more relative to the total concentration of In and Zn, an IGO (InGaO)-based oxide semiconductor material having an In concentration of 70% or more relative to the total concentration of In and Ga, an IGZO (InGaZnO)-based oxide semiconductor material having an In concentration of 50% or more relative to the total concentration of In, Ga, and Zn, an ITO (InSnO)-based oxide semiconductor material having an In concentration of 80% or more relative to the total concentration of In and Sn, an IGZTO (InGaZnSnO)-based oxide semiconductor material having an sum of In and Sn concentrations of 45% or more relative to the total concentration of In, Ga, Zn, and Sn, and an ITZO (InSnZnO)-based oxide semiconductor material having an sum of In and Sn concentrations of 45% or more relative to the total concentration of In, Sn, and Zn.

The first hydrogen capture layer may overlap the gate electrode, the second hydrogen capture layer may not overlap the gate electrode, the flat surface may overlap the gate electrode, and the first inclined surface may not overlap the gate electrode.

The active layer includes a channel portion; a first connecting portion disposed on one side of the channel portion and overlapping the first inclined surface; and a second connecting portion disposed on the other side of the channel portion, and a carrier concentration of the active layer may have a gentle slope from the first connecting portion to the channel portion.

The thickness of the second hydrogen capture layer may be 10% to 60% of the thickness of the first hydrogen capture layer.

The hydrogen capture layer of the thin film transistor further includes a first intermediate layer disposed between the first hydrogen capture layer and the second hydrogen capture layer, and the first intermediate layer can be disposed adjacent to an end of the flat surface and an end of the first inclined surface.

The first inclined surface may have a taper angle of 10 to 60° with respect to the flat surface.

The thin film transistor further includes an insulating film on the hydrogen capture layer of the thin film transistor that may include silicon nitride (SiNx).

The interlayer insulating film further includes a second inclined surface disposed on the other side of the flat surface and having a constant slope with respect to the flat surface, the hydrogen capture layer of the thin film transistor further includes a third hydrogen capture layer disposed on the second inclined surface, and the third hydrogen capture layer can have the same crystal structure as the second hydrogen capture layer.

The third hydrogen capture layer may not overlap the gate electrode, and the second inclined surface may not overlap the gate electrode.

The thin film transistor further includes a gate insulating film disposed between the active layer and the gate electrode, wherein the gate insulating film can expose a portion of the active layer.

The thin film transistor further includes a gate insulating film disposed between the active layer and the gate electrode, wherein the gate insulating film can cover the entire upper surface of the active layer.

Another example of the present disclosure provides a thin film transistor substrate comprising: a base substrate; a first thin film transistor on the base substrate; and a second thin film transistor on the first thin film transistor, wherein the first thin film transistor comprises: a first active layer; a first gate insulating film on the first active layer; a first gate electrode disposed on the first gate insulating film and overlapping the first active layer; a first interlayer insulating film on the first gate electrode; and a lower hydrogen-capture layer on the first interlayer insulating film, wherein the second thin film transistor comprises: a second active layer; a second gate insulating film on the second active layer; a second gate electrode disposed on the second gate insulating film and overlapping the second active layer; a second interlayer insulating film on the second gate electrode; and an upper hydrogen capture layer on the second interlayer insulating film, wherein the first interlayer insulating film includes a first flat surface parallel to the upper surface of the first gate electrode and a first-first inclined surface disposed on one side of the first flat surface and having a constant slope with respect to the first flat surface, the second interlayer insulating film includes a second flat surface parallel to the upper surface of the second gate electrode and a second-first inclined surface disposed on one side of the second flat surface and having a constant slope with respect to the second flat surface, the first gate insulating film exposes a part of the upper surface of the first active layer, the second gate insulating film covers the entire upper surface of the second active layer, the lower hydrogen capture layer includes a first-first hydrogen capture layer disposed on the first flat surface and a first-second hydrogen capture layer disposed on the first-first inclined surface, and the upper hydrogen capture layer includes a second-first hydrogen capture layer disposed on the second flat surface and a second-second hydrogen capture layer disposed on the second-first inclined surface, wherein the first-first hydrogen-capture layer and the first-second hydrogen-capture layer have different crystal structures, and the second-first hydrogen-capture layer and the second-second hydrogen-capture layer have different crystal structures.

A length of the first-first inclined surface may be longer than a length of the second-first inclined surface, and a length of the first-second hydrogen capture layer may be longer than a length of the second-second hydrogen capture layer.

The first-second hydrogen capture layer does not overlap with the first gate insulating film, and the second-second hydrogen capture layer can overlap with the second gate insulating film.

Another example of the present disclosure provides a method for manufacturing a thin film transistor, comprising: forming an active layer; sequentially forming a gate insulating film and a gate electrode on the active layer; forming an interlayer insulating film on the gate electrode; forming a hydrogen-capture pattern layer on the interlayer insulating film; and heat-treating the hydrogen-capture pattern layer to form a hydrogen-capture layer, wherein the interlayer insulating film includes a flat surface parallel to an upper surface of the gate electrode and a first inclined surface disposed on one side of the flat surface and having a constant slope with respect to the flat surface, and the hydrogen-capture layer includes a first hydrogen-capture layer disposed on the flat surface and a second hydrogen-capture layer disposed on the first inclined surface, and the first hydrogen-capture layer and the second hydrogen-capture layer can have different crystal structures.

The heat treating the hydrogen capture pattern layer can be performed at a temperature of 300 to 400°C.

Another example of the present disclosure provides a display apparatus including a thin film transistor.

### BRIEF DESCRIPTION OF THE DRAWINGS

The above and other objects, features and other advantages of the present disclosure will be more clearly understood from the following detailed description taken in conjunction with the accompanying drawings, in which:
FIG. 1 is a plan view of a thin film transistor according to one embodiment of the present invention.
FIG. 2 is a cross-sectional view taken along line I-I' of FIG. 1.
FIG. 3 is a cross-sectional view of a thin film transistor according to another embodiment of the present invention.
FIG. 4 is a cross-sectional view of a thin film transistor according to another embodiment of the present invention.
FIG. 5 is a cross-sectional view of a thin film transistor according to another embodiment of the present invention.
FIG. 6 is a graph showing the change in carrier concentration by active layer section.
FIG. 7 is a cross-sectional view of a thin film transistor substrate according to another embodiment of the present invention.
FIGS. 8A to 8G are process cross-sectional views showing a manufacturing process of a thin film transistor according to one embodiment of the present invention.
FIG. 9 is a schematic diagram of a display apparatus according to one embodiment of the present invention.
Fig. 10 is a circuit diagram for one pixel of Fig. 9.
FIG. 11 is a plan view of the pixels of FIG. 10.
FIG. 12 is a cross-sectional view taken along line III-III' of FIG. 11.
FIG. 13 is a circuit diagram of one pixel of a display apparatus according to another embodiment of the present invention.
FIG. 14 is a cross-sectional view of a part of the pixel shown in FIG. 13.

### DETAILED DESCRIPTION OF THE DISCLOSURE

Advantages and features of the present disclosure and implementation methods thereof will be clarified through following embodiments described with reference to the accompanying drawings. The present disclosure may, however, be embodied in different forms and should not be construed as limited to the embodiments set forth herein. Rather, these embodiments are provided so that this disclosure will be thorough and complete and will fully convey the scope of the present disclosure to those skilled in the art. Further, the present disclosure is only defined by scopes of claims.

A shape, a size, a ratio, an angle and a number disclosed in the drawings for describing embodiments of the present disclosure are merely an example and thus, the present disclosure is not limited to the illustrated details. Like reference numerals refer to like elements throughout the specification. In the following description, when the detailed description of the relevant known function or configuration is determined to unnecessarily obscure the important point of the present disclosure, the detailed description will be omitted.

In a case where 'comprise', 'have' and 'include' described in the present disclosure are used, another portion may be added unless 'only~' is used. The terms of a singular form may include plural forms unless referred to the contrary.

In construing an element, the element is construed as including an error band although there is no explicit description.

In describing a position relationship, for example, when the position relationship is described as 'upon~', 'above~', 'below~' and 'next to~', one or more portions may be disposed between two other portions unless 'just' or 'direct' is used.

Spatially relative terms such as "below", "beneath", "lower", "above", and "upper" may be used herein to easily describe a relationship of one element or elements to another element or elements as illustrated in the drawings. It will be understood that these terms are intended to encompass different orientations of the device in addition to the orientation depicted in the drawings. For example, if the device illustrated in the figure is reversed, the device described to be arranged "below", or "beneath" another device may be arranged "above" another device. Therefore, an exemplary term "below or beneath" may include "below or beneath" and "above" orientations. Likewise, an exemplary term "above" or "on" may include "above" and "below or beneath" orientations.

In describing a temporal relationship, for example, when the temporal order is described as "after," "subsequent," "next," and "before," a case which is not continuous may be included, unless "just" or "direct" is used.

It will be understood that, although the terms "first," "second," etc. may be used herein to describe various elements, these elements should not be limited by these terms. These terms are only used to distinguish one element from another. For example, a first element could be termed a second element, and, similarly, a second element could be termed a first element, without departing from the scope of the present disclosure.

It should be understood that the term "at least one" includes all combinations related with any one item. For example, "at least one among a first element, a second element and a third element" may include all combinations of two or more elements selected from the first, second and third elements as well as each element of the first, second and third elements.

Features of various embodiments of the present disclosure may be partially or overall coupled to or combined with each other and may be variously inter-operated with each other and driven technically as those skilled in the art can sufficiently understand. The embodiments of the present disclosure may be carried out independently from each other or may be carried out together in a co-dependent relationship.

In the addition of reference numerals to the components of each drawing describing embodiments of the present disclosure, the same components can have the same sign as can be displayed on the other drawings.

In the embodiments of the present disclosure, a source electrode and a drain electrode are distinguished for convenience of description, and the source electrode and the drain electrode may be interchanged. The source electrode may be the drain electrode and vice versa. In addition, the source electrode of any one embodiment may be a drain electrode in another embodiment, and the drain electrode of any one embodiment may be a source electrode in another embodiment.

In some embodiments of the present disclosure, for convenience of description, a source area is distinguished from a source electrode, and a drain area is distinguished from a drain electrode, but embodiments of the present disclosure are not limited thereto. The source area may be the source electrode, and the drain area may be the drain electrode. In addition, the source area may be the drain electrode, and the drain area may be the source electrode.

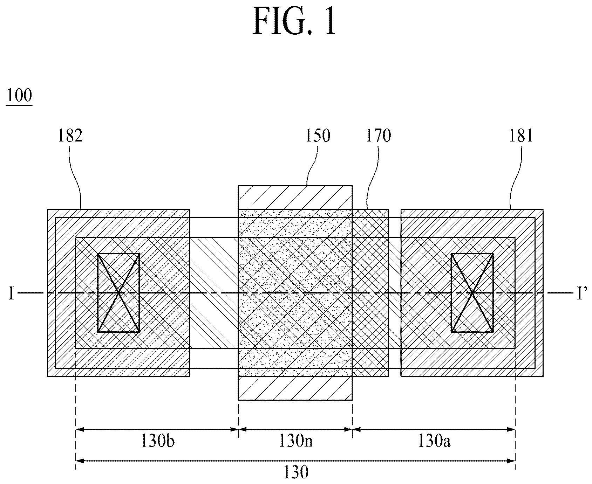

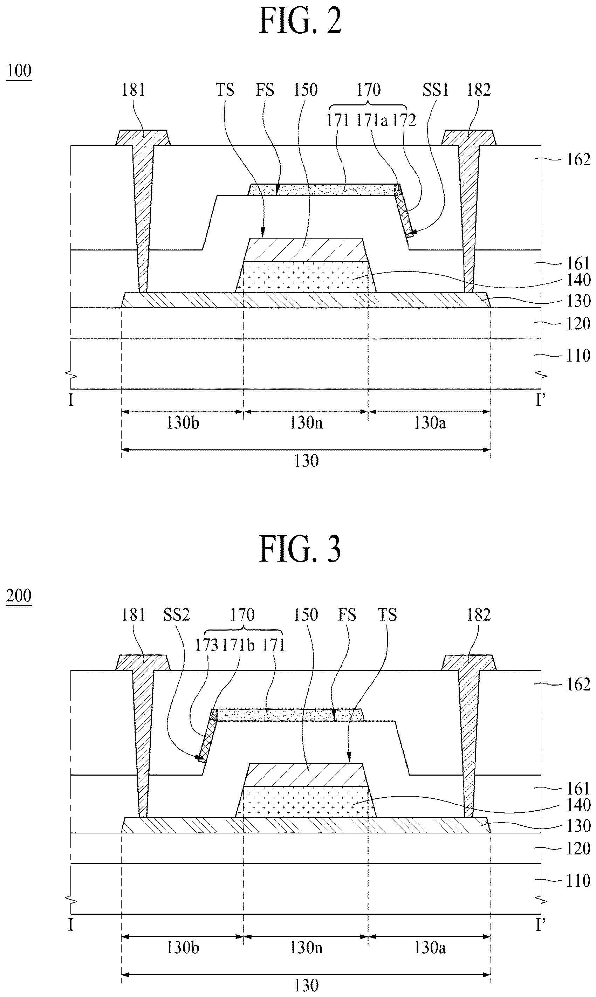

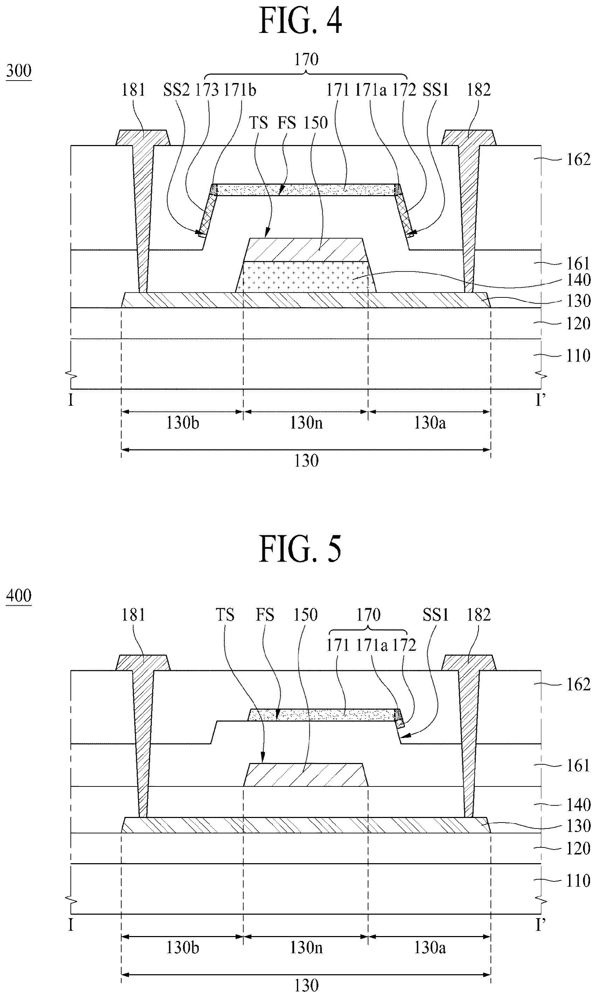

FIG. 1 is a plan view of a thin film transistor (100) according to one embodiment of the present invention. FIG. 2 is a cross-sectional view taken along line I-I' of FIG. 1. FIG. 3 is a cross-sectional view of a thin film transistor (200) according to another embodiment of the present invention. FIG. 4 is a cross-sectional view of a thin film transistor (300) according to another embodiment of the present invention. FIG. 5 is a cross-sectional view of a thin film transistor (400) according to another embodiment of the present invention.

Referring to FIGS. 1 and 2, a thin film transistor (100) according to one embodiment of the present invention includes an active layer (130), a gate electrode (150), an interlayer insulating film (161), and a hydrogen capture layer (170).

Below, components of a thin film transistor (100) according to one embodiment of the present invention are described in detail.

The base substrate (110) may be made of glass or plastic. A transparent plastic having flexible properties, such as polyimide, may be used.

When polyimide is used as the base substrate (110), considering that a high-temperature deposition process is performed on the base substrate (110), a heat-resistant polyimide that can withstand high temperatures can be used. In this case, for forming a thin film transistor, processes such as deposition and etching can be performed while the polyimide substrate is disposed on a carrier substrate made of a highly durable material such as glass.

Although not shown in the drawing, a light-blocking layer (not shown) may be disposed on the base substrate (110).

A light blocking layer (not shown) may be placed between the base substrate (110) and the buffer layer (120). The light blocking layer (not shown) may overlap with the active layer (130). Specifically, the light blocking layer (not shown) may overlap with the channel portion (130n). The light blocking layer (not shown) may block light incident from the outside, thereby protecting the channel portion (130n).

The light-blocking layer (not shown) can be made of a material having light-blocking properties. The light-blocking layer (not shown) can include at least one of an aluminum-based metal such as aluminum (Al) or an aluminum alloy, a molybdenum-based metal such as molybdenum (Mo) or a molybdenum alloy, chromium (Cr), tantalum (Ta), neodymium (Nd), titanium (Ti), and iron (Fe). According to one embodiment of the present invention, the light-blocking layer (not shown) can have electrical conductivity.

Referring to FIGS. 1 and 2, a buffer layer (120) may be disposed on a base substrate (110).

The buffer layer (120) is formed on the base substrate (110) and may be formed of an inorganic material or an organic material. For example, it may include an insulating oxide such as silicon oxide (SiOx) or aluminum oxide (Al2O3).

The buffer layer (120) protects the active layer (130) by blocking impurities such as moisture and oxygen flowing in from the base substrate (110) and serves to flatten the upper portion of the base substrate (110), and can be formed as a single layer or multiple layers.

When the buffer layer (120) has multiple layers, each of the multiple layers can be formed of different materials.

Referring to FIGS. 1 and 2, an active layer (130) may be disposed on a buffer layer (120).

The active layer (130) includes a channel portion (130n), a first connecting portion (130a) disposed on one side of the channel portion (130n), and a second connecting portion (130b) disposed on the other side of the channel portion (130n).

For example, referring to FIG. 2, the channel portion (130n) is disposed between the first connecting portion (130a) and the second connecting portion (130b). For example, the first connecting portion (130a) and the second connecting portion (130b) are spaced apart from each other with the channel portion (130n) therebetween. For example, the channel portion (130n) overlaps the gate electrode (150).

According to one embodiment of the present invention, the active layer (130) may include an oxide semiconductor material.

For example, the oxide semiconductor material of the active layer (130) may include, for example, at least one of an IZO (InZnO)-based oxide semiconductor material, an IGO (InGaO)-based oxide semiconductor material, an ITO (InSnO)-based oxide semiconductor material, an IGZO (InGaZnO)-based oxide semiconductor material, an IGZTO (InGaZnSnO)-based oxide semiconductor material, a GZTO (GaZnSnO)-based oxide semiconductor material, a GZO (GaZnO)-based oxide semiconductor material, an ITZO (InSnZnO)-based oxide semiconductor material, and a FIZO (FeInZnO)-based oxide semiconductor material.

The first connecting portion (130a) and the second connecting portion (130b) can be formed by selective conductorization for the active layer (130) made of a semiconductor material. According to one embodiment of the present invention, imparting conductivity to a specific portion of the active layer (130) so that it can function as a conductor, which is called selective conductorization.

For example, the active layer (130) can be selectively conductorized by ion doping. As a result, the first connecting portion (130a) and the second connecting portion (130b) can be formed. However, one embodiment of the present invention is not limited thereto, and the active layer (130) can also be selectively conductorized by other methods known in the art.

The first connecting portion (130a) and the second connecting portion (130b) do not overlap with the gate electrode (150). The first connecting portion (130a) and the second connecting portion (130b) have superior electrical conductivity and high mobility compared to the channel portion (130n). Therefore, the first connecting portion (130a) and the second connecting portion (130b) can each function as wiring.

According to another embodiment of the present invention, the active layer (130) may have a crystalline structure. For example, after the active layer (130) is patterned, it may be crystallized by heat treatment so that the active layer (130) has a crystalline structure. Specifically, the transformation of an amorphous layer into a crystalline structure is referred to as "crystallization."

According to one embodiment of the present invention, when, in a cross-section of a certain layer, the total area of regions having a grain size of 1 nm or more accounts for 50% or more of the entire cross-sectional area, the layer is regarded as a layer having a crystalline structure.

However, according to one embodiment of the present invention, the active layer (130) may be crystallized by heat treatment after patterning and before the formation of the hydrogen capture pattern layer (170m). In this case, the active layer (130) may be heat-treated at a temperature of about 400°C. However, the present invention is not limited thereto, and the active layer (130) may be crystallized simultaneously with the heat treatment process for the hydrogen capture pattern layer (170m), which will be described below.

According to one embodiment of the present invention, by having a crystalline structure, the active layer (130) can effectively suppress hydrogen diffusion. In general, when the active layer has an amorphous structure, hydrogen introduced from the outside may easily diffuse in the lateral direction within the channel portion (130n).

In contrast, since a crystalline structure has more limited diffusion paths for hydrogen compared to an amorphous structure, when the active layer (130) has a crystalline structure, even if a large amount of hydrogen is present, lateral diffusion into the channel portion (130n) is significantly suppressed.

According to one embodiment of the present invention, selective conductorization may additionally be performed on the crystallized active layer (130). However, the present invention is not limited thereto.

According to one embodiment of the present invention, the active layer (130) may have a multilayer structure.

According to one embodiment of the present invention, the thin film transistor (100) may further include a gate insulating film (140) between the active layer (130) and the gate electrode (150). Specifically, the gate insulating film (140) may expose a part of the active layer (130). However, one embodiment of the present invention is not limited thereto, and the gate insulating film (140) may cover the entire upper surface of the active layer (130) (see FIG. 5).

Referring to FIG. 5, a second hydrogen capture layer (172) may be disposed on the first inclined surface (SS1). At this time, the length of the first inclined surface (SS1) illustrated in FIGS. 1 to 4 may be longer than the length of the first inclined surface (SS1) illustrated in FIG. 5. In addition, the length of the second hydrogen capture layer (172) illustrated in FIGS. 1 to 4 may be longer than the length of the second hydrogen capture layer (172) illustrated in FIG. 5. At this time, the length of the second hydrogen capture layer (172) is measured in a direction parallel to the first inclined surface (SS 1).

Referring to FIG. 5, the second hydrogen capture layer (172) disposed on the first inclined surface (SS1) may overlap with the gate insulating film (140). On the other hand, referring to FIGS. 1 to 4, the second hydrogen capture layer (172) disposed on the first inclined surface (SS1) may not overlap with the gate insulating film (140).

The gate insulating film (140) may include at least one of silicon oxide, silicon nitride, and metal oxide. The gate insulating film (140) may have a single film structure or a multilayer film structure. The gate insulating film (140) protects the channel portion (130n).

Referring to FIGS. 1 and 2, a gate electrode (150) is disposed on a gate insulating film (140). The gate electrode (150) overlaps with a channel portion (130n) of the active layer (130).

The gate electrode (150) may include at least one of an aluminum series metal such as aluminum (Al) or an aluminum alloy, a silver series metal such as silver (Ag) or a silver alloy, a copper series metal such as copper (Cu) or a copper alloy, a molybdenum series metal such as molybdenum (Mo) or a molybdenum alloy, chromium (Cr), tantalum (Ta), neodymium (Nd), and titanium (Ti). The gate electrode (150) may also have a multilayer film structure including at least two conductive films having different physical properties.

Referring to FIGS. 1 and 2, an interlayer insulating film (161) is disposed on the gate electrode (150). The interlayer insulating film (161) is an insulating layer made of an insulating material. The interlayer insulating film (161) may be made of an organic material, an inorganic material, or a laminate of an organic material layer and an inorganic material layer.

According to one embodiment of the present invention, the interlayer insulating film (161) includes a flat surface (FS) parallel to the upper surface (TS) of the gate electrode (150) and a first inclined surface (SS1) disposed on one side of the flat surface (FS) and having a constant slope with respect to the flat surface (FS).

For example, the upper surface (TS) of the gate electrode (150) and the flat surface (FS) of the interlayer insulating film (161) may each be parallel to the upper surface of the base substrate (110). For example, the flat surface (FS) of the interlayer insulating film (161) may overlap with the gate electrode (150), and the first inclined surface (SS1) of the interlayer insulating film (161) does not overlap with the gate electrode (150).

Referring to FIG. 3, the interlayer insulating film (161) may include a second inclined surface (SS2) disposed on the other side of the flat surface (FS) and having a constant slope with respect to the flat surface (FS).

For example, the flat surface (FS), the first inclined surface (SS1), and the second inclined surface (SS2) of the interlayer insulating film (161) may be connected. For example, the flat surface (FS) may be disposed between the first inclined surface (SS1) and the second inclined surface (SS2). The second inclined surface (SS2) may not overlap with the gate electrode (150).

In FIGS. 2 and 3, the first inclined surface (SS1) may be disposed toward the first connecting portion (130a) of the active layer (130), and the second inclined surface (SS2) may be disposed toward the second connecting portion (130b) of the active layer (130). For example, the first inclined surface (SS1) may overlap the first connecting portion (130a) of the active layer (130), and the second inclined surface (SS2) may overlap the second connecting portion (130b) of the active layer (130).

According to one embodiment of the present invention, a hydrogen capture layer (170) may be disposed on an interlayer insulating film (161).

According to one embodiment of the present invention, the hydrogen capture layer (170) may be made of an oxide semiconductor material.

For example, the oxide semiconductor material may include at least one of the following oxide semiconductor materials: an IZO (InZnO) type having an In concentration of 50% or more relative to the total concentration of In and Zn, an IGO (InGaO) type having an In concentration of 70% or more relative to the total concentration of In and Ga, an IGZO (InGaZnO) type having an In concentration of 50% or more relative to the total concentration of In, Ga, and Zn, an ITO (InSnO) type having an In concentration of 80% or more relative to the total concentration of In and Sn, an IGZTO (InGaZnSnO) type having an sum of In and Sn concentrations of 45% or more relative to the total concentration of In, Ga, Zn, and Sn, and an ITZO (InSnZnO) type having an sum of In and Sn concentrations of 45% or more relative to the total concentration of In, Sn, and Zn.

For example, in the case of the IZO (InZnO) type, the ratio of In and Zn can be 5:5, 6:4, 7:3. Also, in the case of the IGO (InGaO) type, the ratio of In and Ga can be 7:3, 8:2, 9:1.

If the concentration of In is less than 50% of the total concentration of In and Zn in the IZO (InZnO) type, or if the concentration of In is less than 70% of the total concentration of In and Ga in the IGO (InGaO) type, or if the concentration of In is less than 50% of the total concentration of In, Ga, and Zn in the IGZO (InGaZnO) type, or if the concentration of In is less than 80% of the total concentration of In and Sn in the ITO (InSnO) type, or if the sum of the concentrations of In and Sn is less than 45% of the total concentration of In, Ga, Zn, and Sn in the IGZTO (InGaZnSnO) type, or if the sum of the concentrations of In and Sn is less than 45% of the total concentration of In, Sn, and Zn in the ITZO (InSnZnO) type, the concentration of indium (In) in the hydrogen capture layer (170) may be low, making it difficult for the hydrogen capture layer (170) to have a complete crystal structure. As a result, a problem may arise in which formation of crystal grains within the hydrogen capture layer (170) becomes difficult.

According to one embodiment of the present invention, the active layer (130) may be made of the same material as the hydrogen capture layer (170).

According to one embodiment of the present invention, the hydrogen capture layer (170) may include a first hydrogen capture layer (171) disposed on a flat surface (FS) of an interlayer insulating film (161) and a second hydrogen capture layer (172) disposed on a first inclined surface (SS1) (see FIG. 2).

According to one embodiment of the present invention, the hydrogen capture layer (170) may further include a first intermediate layer (171a) disposed between the first hydrogen capture layer (171) and the second hydrogen capture layer (172). The first intermediate layer (171a) may be disposed adjacent to an end of the flat surface (FS) and adjacent to an end of the first inclined surface (SS1).

According to one embodiment of the present invention, the hydrogen capture layer (170) may include a third hydrogen capture layer (173) disposed on the second inclined surface (SS2) of the interlayer insulating film (161) (see FIG. 3).

According to one embodiment of the present invention, the hydrogen capture layer (170) may further include a second intermediate layer (171b) disposed between the first hydrogen capture layer (171) and the third hydrogen capture layer (173). The second intermediate layer (171b) may be disposed adjacent to an end of the flat surface (FS) and adjacent to an end of the second inclined surface (SS2).

For example, the first hydrogen capture layer (171) may overlap with the gate electrode (150). For example, the second hydrogen capture layer (172) may not overlap with the gate electrode (150) but may overlap with the first connecting portion (130a). For example, the third hydrogen capture layer (173) may not overlap with the gate electrode (150) but may overlap with the second connecting portion (130b).

According to one embodiment of the present invention, the hydrogen capture layer (170) may include at least one of the second hydrogen capture layer (172) and the third hydrogen capture layer (173). For example, FIGS. 1 and 2 illustrate a view in which the hydrogen capture layer (170) includes a first hydrogen capture layer (171) and a second hydrogen capture layer (172). For example, FIG. 3 illustrates a view in which the hydrogen capture layer (170) includes a first hydrogen capture layer (171) and a third hydrogen capture layer (173). For example, FIG. 4 illustrates a view in which the hydrogen capture layer (170) includes a first hydrogen capture layer (171), a second hydrogen capture layer (172), and a third hydrogen capture layer (173).

According to one embodiment of the present invention, the first hydrogen capture layer (171) and the second hydrogen capture layer (172) may have different crystal structures.

The first hydrogen capture layer (171) and the second hydrogen capture layer (172) are distinguished based on the content of crystal grains included in the oxide semiconductor layer. Specifically, the first hydrogen capture layer (171) and the second hydrogen capture layer (172) are distinguished based on the ratio of crystal grains having a particle size of 1 nm or more. At this time, the first hydrogen capture layer (171) may have first crystal grain having a particle size of 1 nm or more, the second hydrogen capture layer (172) may have second crystal grain having a particle size of 1 nm or more, and the third hydrogen capture layer (173) may have third crystal grain having a particle size of 1 nm or more.

For example, the ratio of the first crystal grain having a particle size of 1 nm or more of the first hydrogen capture layer (171) may be 80% or more with respect to the total area of the cross-section. For example, the ratio of the second crystal grain having a particle size of 1 nm or more of the second hydrogen capture layer (172) may be 70% or less with respect to the total area of the cross-section. For example, the ratio of the third crystal grain having a particle size of 1 nm or more of the third hydrogen capture layer (173) may be 70% or less with respect to the total area of the cross-section. The third hydrogen capture layer (173) may have the same crystal structure as the second hydrogen capture layer (172). For example, the ratio of the crystal grains having a particle size of 1 nm or more of the first intermediate layer (171a) and the second intermediate layer (171b) may be more than 70% and less than 80% with respect to the total area of the cross-section. For example, the ratio of crystal grains having a particle size of 1 nm or more in the first intermediate layer (171a) and the second intermediate layer (171b) may correspond to a value between the ratio of the first hydrogen capture layer (171) and the ratio of the second hydrogen capture layer (172). Alternatively, the ratio of crystal grains having a particle size of 1 nm or more in the first intermediate layer (171a) and the second intermediate layer (171b) may correspond to a value between the ratio of the first hydrogen capture layer (171) and the ratio of the third hydrogen capture layer (173).

According to one embodiment of the present invention, a crystal grain is defined as a collection of atoms having a regular arrangement. Atoms have a regular arrangement within a crystal grain. A lump in which atoms within the crystal grain have a regular arrangement can also be defined as a crystal grain.

According to one embodiment of the present invention, the arrangement state of atoms can be confirmed by a cross-sectional image captured by a transmission electron microscope (TEM). A cross-sectional image of an oxide semiconductor layer can be obtained by a transmission electron microscope (TEM), and in the cross-sectional image of the oxide semiconductor layer, crystal grains have a shape of a single aggregate or a two-dimensional lump having a boundary.

Crystal grain has a grain size. In a cross-sectional image taken by a transmission electron microscope (TEM), the length of the longest axis of a crystal grain is called the grain size.

According to one embodiment of the present invention, when the ratio of crystal grains having a grain size of 1 nm or more in a cross-sectional image of an oxide semiconductor layer photographed by a transmission electron microscope (TEM) is 80% or more of the total cross-sectional area, the oxide semiconductor layer is defined as having an excellent crystalline structure. Furthermore, when the ratio of crystal grains having a grain size of 1 nm or more in a cross-sectional image of the oxide semiconductor layer photographed by a transmission electron microscope (TEM) is 70% or less of the total cross-sectional area, the oxide semiconductor layer is defined as having an unstable crystalline structure.

The better the crystal structure of the oxide semiconductor layer, the more effectively it can suppress or capture hydrogen flowing in from the outside. Specifically, if the oxide semiconductor layer has an unstable crystal structure, it may be difficult to block hydrogen flowing in from the outside compared to a layer having an excellent crystal structure.

According to one embodiment of the present invention, the first hydrogen capture layer (171) disposed on the flat surface (FS) of the interlayer insulating film (161) may have an excellent crystalline structure, and the second hydrogen capture layer (172) disposed on the first inclined surface (SS1) may have an unstable structure.

That is, the hydrogen capture capabilities of the first hydrogen capture layer (171) and the second hydrogen capture layer (172) can be differentiated.

Hydrogen flowing in from above can be effectively blocked by the first hydrogen capture layer (171) disposed on the flat surface (FS). In addition, the carrier concentration profile at the first connecting portion (130a) can be controlled by the second hydrogen capture layer (172) disposed on the first inclined surface (SS 1).

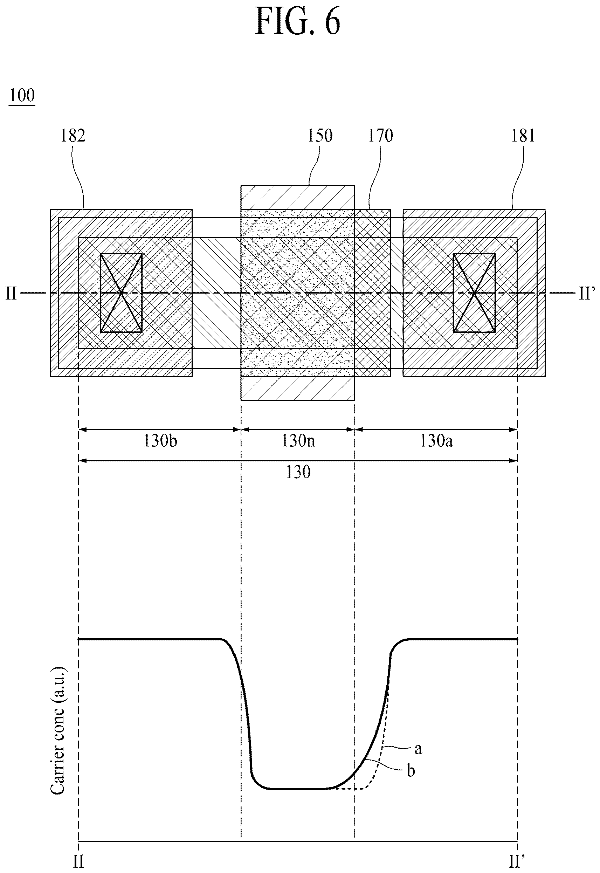

Unlike the present invention, when a hydrogen capture layer having an excellent crystal structure is disposed on the first inclined surface (SS1), hydrogen flowing into the first connecting portion (130a) can be blocked more effectively, but the carrier concentration can rapidly decrease as it goes from the first connecting portion (130a) toward the channel portion (130n) (see line (a) in FIG. 6).

According to the present invention, when a second hydrogen capture layer (172) having an unstable crystal structure is disposed on the first inclined surface (SS 1), some hydrogen is transmitted to the first connecting portion (130a). As a result, the gradient of carrier concentration can become more gentle as it goes from the first connecting portion (130a) to the channel portion (130n). Specifically, the gradient of carrier concentration can gently decrease as it goes from the first connecting portion (130a) to the channel portion (130n) (see line (b) in FIG. 6).

As the gradient of carrier concentration becomes more gentle from the first connecting portion (130a) toward the channel portion (130n), the HCS (Hot Carrier Stress) reliability of the thin film transistor can be improved.

Even when the third hydrogen capture layer (173) is disposed on the second inclined surface (SS2), the same applies to the third hydrogen capture layer (173) (see FIG. 3). Even when the second hydrogen capture layer (172) is disposed on the first inclined surface (SS1) and the third hydrogen capture layer (173) is disposed on the second inclined surface (SS2), the same applies (see FIG. 4).

According to one embodiment of the present invention, the first hydrogen capture layer (171) may have at least one of a (400) crystal plane, a (222) crystal plane, a (220) crystal plane, a (311) crystal plane, and a (0016) crystal plane.

According to one embodiment of the present invention, the first hydrogen capture layer (171) may have at least one of a cubic crystal structure, a bixbyite crystal structure, a spinel crystal structure, and a hexagonal crystal structure.

According to one embodiment of the present invention, the thickness of the second hydrogen capture layer (172) may be 10% to 60% of the thickness of the first hydrogen capture layer (171).

For example, the first hydrogen capture layer (171) may have a thickness of 30 to 40 nm. The second hydrogen capture layer (172) and the third hydrogen capture layer (173) may each have a thickness of 3 to 24 nm. However, the present invention is not limited thereto.

At this time, the thickness is measured in a vertical direction based on the surface of the interlayer insulating film (161).

When annealing is performed on the hydrogen capture layer (170), the first hydrogen capture layer (171) disposed on the flat surface (FS) of the interlayer insulating film (161) has a thickness sufficient for crystallization to proceed and thus can have an excellent crystal structure.

If the thickness of the second hydrogen capture layer (172) is less than 10% of the thickness of the first hydrogen capture layer (171), the thickness of the second hydrogen capture layer (172) may become excessively thin, and crystallization may not occur at all in the second hydrogen capture layer (172). As a result, there may be a problem in that hydrogen introduced from the outside cannot be suppressed at all.

When the thickness of the second hydrogen capture layer (172) exceeds 60% of the thickness of the first hydrogen capture layer (171), crystallization may occur in the second hydrogen capture layer (172). As a result, hydrogen flowing into the first connecting portion (130a) can be blocked more effectively, but the carrier concentration may rapidly decrease from the first connecting portion (130a) toward the channel portion (130n), and the HCS (Hot Carrier Stress) phenomenon of the thin film transistor may occur, causing deterioration in the thin film transistor.

The thickness of the third hydrogen capture layer (173) may be 10% to 60% of the thickness of the first hydrogen capture layer (171). The description of the thickness of the third hydrogen capture layer (173) is omitted because it overlaps with the description of the thickness of the second hydrogen capture layer (172).

According to one embodiment of the present invention, the first inclined surface (SS1) can have a taper angle of 10 to 60° with respect to the flat surface (FS). The taper angle is measured with respect to a surface parallel to the flat surface (FS).

When the taper angle of the first inclined surface (SS1) is less than 10°, the thickness of the second hydrogen capture layer (172) at the first inclined surface (SS1) may become excessively thick. In other words, crystallization may occur in the second hydrogen capture layer (172). As a result, hydrogen flowing into the first connecting portion (130a) may be more effectively blocked, but the carrier concentration may rapidly decrease from the first connecting portion (130a) toward the channel portion (130n), and a hot carrier stress (HCS) phenomenon of the thin film transistor may occur, resulting in deterioration within the thin film transistor.

If the taper angle of the first inclined surface (SS1) exceeds 60°, the thickness of the second hydrogen capture layer (172) disposed on the first inclined surface (SS1) may become excessively thin. As a result, crystallization may not proceed at all in the second hydrogen capture layer (172). As a result, a problem may occur in which hydrogen flowing in from the outside is not suppressed at all. Accordingly, as it goes from the first connecting portion (130a) toward the channel portion (130n), the carrier concentration may become low, and the corresponding graph may have a steep slope.

The second inclined surface (SS2) may have a taper angle of 10 to 60° with respect to the flat surface (FS). The description of the taper angle of the second inclined surface (SS2) is omitted as it overlaps with the description of the taper angle of the first inclined surface (SS1).

The first inclined surface (SS1) and the second inclined surface (SS2) may have the same taper angle and may not be parallel to each other.

According to one embodiment of the present invention, an insulating film (162) may be disposed on an interlayer insulating film (161). The insulating film (162) is an insulating layer made of an insulating material. The insulating film (162) may be made of an organic material, an inorganic material, or a laminate of an organic material layer and an inorganic material layer.

The insulating film (162) may be made of the same material as the interlayer insulating film (161), or may be made of a different material with the interlayer insulating film (161). For example, the insulating film (162) may include silicon nitride (SiNx). The insulating film (162) may be one layer or multiple layers.

Referring to FIGS. 1 and 2, a source electrode (181) and a drain electrode (182) are disposed on an insulating film (162).

The source electrode (181) and the drain electrode (182) may each include at least one of an aluminum series metal such as aluminum (Al) or an aluminum alloy, a silver series metal such as silver (Ag) or a silver alloy, a copper series metal such as copper (Cu) or a copper alloy, a molybdenum series metal such as molybdenum (Mo) or a molybdenum alloy, chromium (Cr), tantalum (Ta), neodymium (Nd), and titanium (Ti). The source electrode (181) and the drain electrode (182) may each have a multilayer film structure including at least two conductive films having different physical properties.

Referring to FIGS. 1 and 2, the source electrode (181) and the drain electrode (182) are each connected to the active layer (130) through a contact hole. Specifically, the source electrode (181) and the drain electrode (182) are connected to the active layer (130) by contacting the second connecting portion (130b) and the first connecting portion (130a), respectively.

FIG. 6 is a graph showing the change in carrier concentration by active layer section.

Fig. 6 is a graph showing the change in carrier concentration according to II-II' in the active layer (130) of the thin film transistor (100) according to Fig. 1. Here, the active layer (130) may be made of an oxide semiconductor material.

In the graph of Fig. 6, the horizontal axis sequentially indicates the second connecting portion (130b), the channel portion (130n), and the first connecting portion (130a), and the horizontal axis of Fig. 6 may correspond to the distance measured from the left end of the active layer (130) illustrated in Fig. 6.

The vertical axis of the graph in FIG. 6 represents carrier concentration (au).

Referring to Fig. 6, the hydrogen capture layer (170) is disposed to overlap the channel portion (130n) and the first connecting portion (130a). As a result, hydrogen is only partially transmitted through the first connecting portion (130a). As a result, the gradient of carrier concentration may become more gentle as it moves from the first connecting portion (130a) toward the channel portion (130n). Specifically, the gradient of carrier concentration may decrease as it moves from the first connecting portion (130a) toward the channel portion (130n).

As described above, line (a) of FIG. 6 illustrates that, unlike the present invention, when a hydrogen capture layer having an excellent crystalline structure is disposed on the first inclined surface (SS1), hydrogen flowing into the first connecting portion (130a) can be blocked more effectively, but the carrier concentration rapidly decreases as it goes from the first connecting portion (130a) toward the channel portion (130n).

Line (b) of FIG. 6 illustrates that, according to the present invention, when a second hydrogen capture layer (172) having an unstable crystalline structure is disposed on the first inclined surface (SS1), some hydrogen is transmitted to the first connecting portion (130a). As a result, the gradient of carrier concentration can gently decrease as it goes from the first connecting portion (130a) toward the channel portion (130n).

On the other hand, when the hydrogen capture layer (170) does not overlap with the second connecting portion (130b), it may be difficult to effectively block hydrogen flowing into the second connecting portion (130b), and the carrier concentration may rapidly decrease as it goes from the second connecting portion (130b) toward the channel portion (130n).

Even if the hydrogen capture layer (170) overlaps either the first connection portion (130a) or the second connection portion (130b), the thin film transistor according to the present invention can improve HCS (Hot Carrier Stress) reliability and prevent deterioration within thin film transistors.

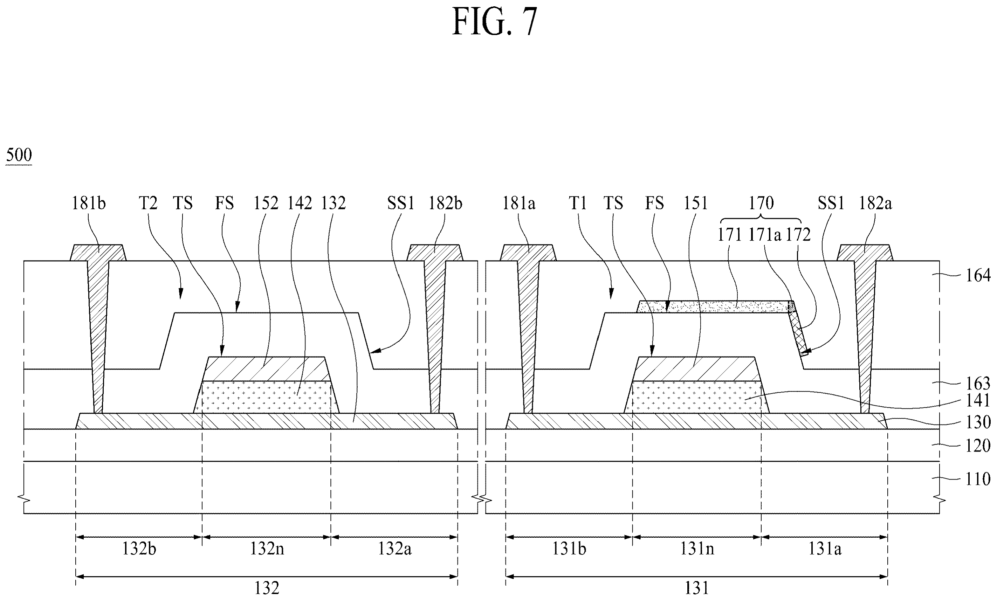

FIG. 7 is a cross-sectional view of a thin film transistor substrate (500) according to another embodiment of the present invention.

According to one embodiment of the present invention, a thin film transistor substrate (500) includes a base substrate (110), a first thin film transistor (T1) and a second thin film transistor (T2) disposed on the base substrate (110) and spaced apart from each other.

The first thin film transistor (T1) may correspond to the thin film transistor (100, 200, 300, 400) according to FIGS. 1 to 5.

Specifically, the first thin film transistor (T1) includes a first active layer (131), a first gate insulating film (141), a first gate electrode (151), an interlayer insulating film (163), a hydrogen capture layer (170), a source electrode (181a), and a drain electrode (182a).

The first active layer (131), the first gate insulating film (141), the first gate electrode (151), the interlayer insulating film (163), the hydrogen capture layer (170), the source electrode (181a), and the drain electrode (182a) of the first thin film transistor (T1) correspond to the active layer (130), the gate insulating film (140), the gate electrode (150), the interlayer insulating film (161), the hydrogen capture layer (170), the source electrode (181), and the drain electrode (182) of the thin film transistors (100, 200, 300, and 400) according to FIGS. 1 to 5.

Therefore, a description of the components of the first thin film transistor (T1) is omitted.

The second thin film transistor (T2) includes a second active layer (132), a second gate insulating film (142), a second gate electrode (152), an interlayer insulating film (163), a source electrode (181b), and a drain electrode (182b).

Specifically, the second thin film transistor (T2) does not have a hydrogen capture layer (170) disposed thereon. For example, the hydrogen capture layer (170) does not overlap with the second thin film transistor (T2). For example, the hydrogen capture layer (170) does not overlap with the second active layer (132) and the second gate electrode (152) of the second thin film transistor (T2).

The second active layer (132), the second gate insulating film (142), the second gate electrode (152), the interlayer insulating film (163), the source electrode (181b), and the drain electrode (182b) of the second thin film transistor (T2) correspond to the active layer (130), the gate insulating film (140), the gate electrode (150), the interlayer insulating film (161), the source electrode (181), and the drain electrode (182) of the thin film transistors (100, 200, 300, 400) according to FIGS. 1 to 5.

Therefore, a description of the components of the second thin film transistor (T2) is omitted.

In order for a display apparatus driven by current to have excellent gray scale expression capability, it is advantageous for the s-factor of the thin film transistor driving the pixels of the display apparatus to be larger.

The sub-threshold swing (s-factor) of a thin film transistor is the reciprocal value of the slope of a graph of drain-source current (I_{DS}) versus gate voltage (V_{G}) characteristics of the thin film transistor (not shown) in the threshold voltage (Vth) section. As the s-factor increases, the rate of change of the drain-source current (I_{DS}) versus the gate voltage (V_{G}) in the threshold voltage (Vth) section decreases. Accordingly, the gray scale expression capability of a display apparatus driven by such a thin film transistor can be improved.

The first thin film transistor (T1) can have low current characteristics and a large s-factor value by controlling hydrogen flowing in from the outside by including a hydrogen capture layer (170).

The second thin film transistor (T2) can have excellent current characteristics because it does not include a hydrogen capture layer.

Specifically, the first thin film transistor (T1) is applied to a driving transistor of a pixel driving circuit (PDC) of a display apparatus that requires excellent gray scale expression capability, and the second thin film transistor (T2) is applied to a switching transistor of a pixel driving circuit (PDC) that requires excellent current characteristics, or can be disposed in a gate driving section of the display apparatus.

According to one embodiment of the present invention, a second thin film transistor (not shown) may be disposed on a first thin film transistor (not shown). For example, the first thin film transistor (not shown) may be a thin film transistor (100, 200, 300) illustrated in FIGS. 1 to 4, and the second thin film transistor (not shown) may be a thin film transistor (400) illustrated in FIG. 5.

For example, a first thin film transistor (not shown) may include a first active layer, a first gate insulating film on the first active layer, a first gate electrode disposed on the first gate insulating film and overlapping the first active layer, a first interlayer insulating film on the first gate electrode, and a lower hydrogen capture layer on the first interlayer insulating film. In addition, a second thin film transistor (not shown) may include a second active layer, a second gate insulating film on the second active layer, a second gate electrode disposed on the second gate insulating film and overlapping the second active layer, a second interlayer insulating film on the second gate electrode, and an upper hydrogen capture layer on the second interlayer insulating film.

At this time, the first active layer, the first gate insulating film, the first gate electrode, the first interlayer insulating film, and the lower hydrogen capture layer of the first thin film transistor (not shown) correspond to the active layer (130), the gate insulating film (140), the gate electrode (150), the interlayer insulating film (161), and the hydrogen capture layer (170) illustrated in FIGS. 1 to 4. The second active layer, the second gate insulating film, the second gate electrode, the second interlayer insulating film, and the upper hydrogen capture layer of the second thin film transistor (not shown) correspond to the active layer (130), the gate insulating film (140), the gate electrode (150), the interlayer insulating film (161), and the hydrogen capture layer (170) illustrated in FIG. 5.

According to one embodiment of the present invention, the first interlayer insulating film may include a first flat surface parallel to the upper surface of the first gate electrode and a first-first inclined surface disposed on one side of the first flat surface and having a constant slope with respect to the first flat surface, and the second interlayer insulating film may include a second flat surface parallel to the upper surface of the second gate electrode and a second-first inclined surface disposed on one side of the second flat surface and having a constant slope with respect to the second flat surface. In this case, the first flat surface and the first-first inclined surface may correspond to the flat surface (FS) and the first inclined surface (SS1) illustrated in FIGS. 1 to 4, and the second flat surface and the second-first inclined surface may correspond to the flat surface (FS) and the first inclined surface (SS1) illustrated in FIG. 5.

According to one embodiment of the present invention, the lower hydrogen capture layer may include a first-first hydrogen capture layer disposed on the first flat surface and a first-second hydrogen capture layer disposed on the first-first inclined surface, and the upper hydrogen capture layer may include a second-first hydrogen capture layer disposed on the second flat surface and a second-second hydrogen capture layer disposed on the second-first inclined surface. At this time, the first-first hydrogen capture layer and the first-second hydrogen capture layer may correspond to the first hydrogen capture layer (171) and the second hydrogen capture layer (172) illustrated in FIGS. 1 to 4, respectively, and the second-first hydrogen capture layer and the second-second hydrogen capture layer may correspond to the first hydrogen capture layer (171) and the second hydrogen capture layer (172) illustrated in FIG. 5, respectively.

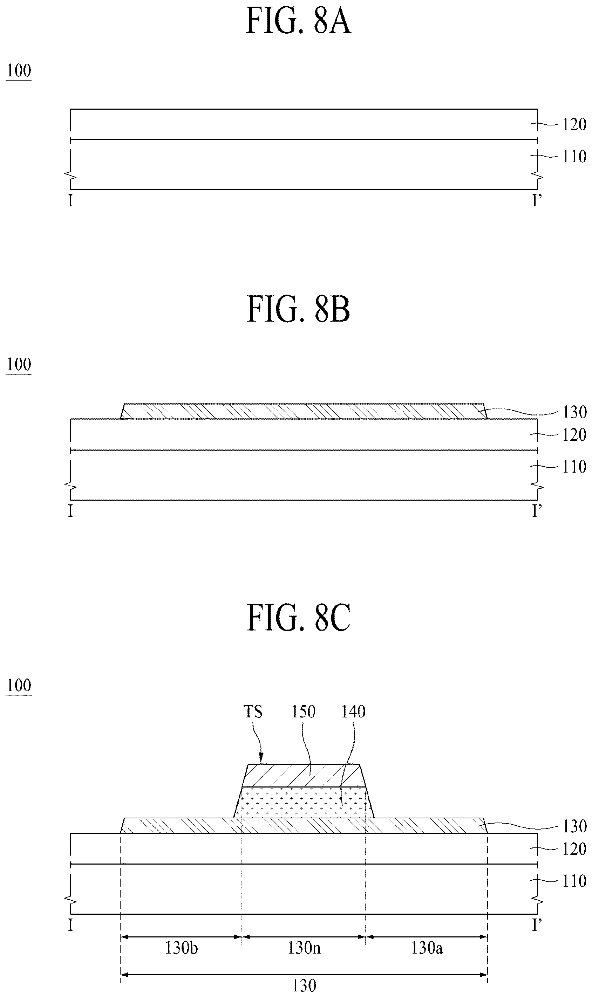

FIGS. 8A to 8G are process cross-sectional views showing a manufacturing process of a thin film transistor (100) according to one embodiment of the present invention. FIGS. 8A to 8G correspond to the I-I' cross-section of FIG. 2.

Referring to FIG. 8A, a buffer layer (120) can be formed on a base substrate (110).

Referring to FIG. 8B, an active layer (130) can be formed on a buffer layer (120). The active layer (130) can be formed by patterning after forming an active material layer. The active layer (130) can include an oxide semiconductor material.

According to another embodiment of the present invention, the active layer (130) may have a crystalline structure. For example, after the active layer (130) is patterned, it may be crystallized by heat treatment so that the active layer (130) has a crystalline structure.

According to one embodiment of the present invention, the active layer (130) may be crystallized by heat treatment after patterning and before the formation of the hydrogen capture pattern layer (170m). In this case, the active layer (130) may be heat-treated at a temperature of about 400°C. However, the present invention is not limited thereto, and the active layer (130) may be crystallized simultaneously with the heat treatment process for the hydrogen capture pattern layer (170m), which will be described below.

Referring to FIG. 8C, a gate insulating film (140) and a gate electrode (150) may be sequentially formed on an active layer (130). The gate insulating film (140) may expose a part of the active layer (130). However, one embodiment of the present invention is not limited thereto, and may cover the entire upper surface of the active layer (130).

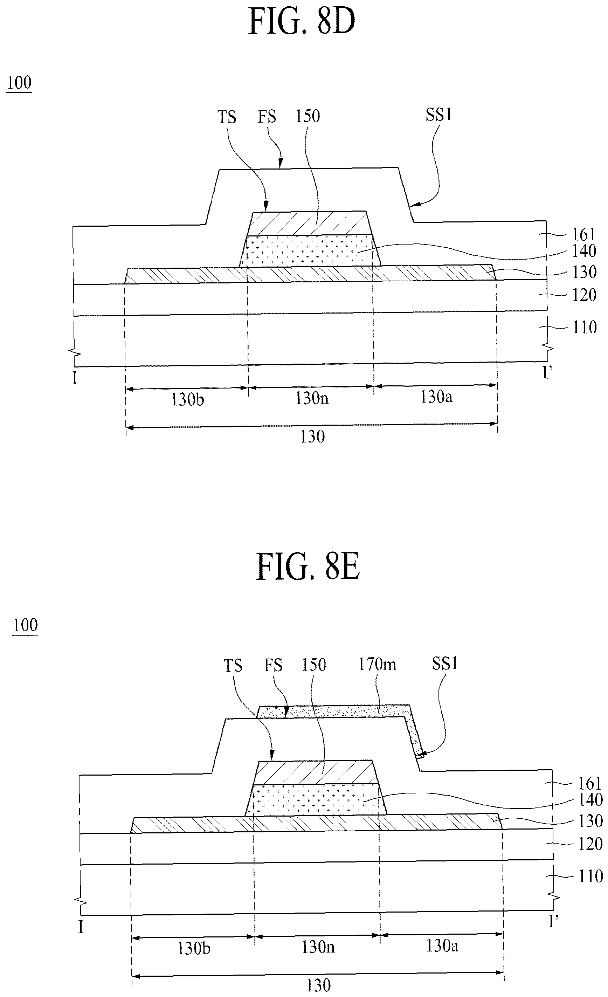

Referring to FIG. 8D, an interlayer insulating film (161) may be formed on the gate electrode (150). The interlayer insulating film (161) includes a flat surface (FS) parallel to the upper surface (TS) of the gate electrode (150) and a first inclined surface (SS1) disposed on one side of the flat surface (FS) and having a constant slope with respect to the flat surface (FS). The interlayer insulating film (161) may include a second inclined surface (SS2) disposed on the other side of the flat surface (FS) and having a constant slope with respect to the flat surface (FS) (see FIG. 3).

Referring to FIG. 8E, a hydrogen capture pattern layer (170m) can be formed on an interlayer insulating film (161). The hydrogen capture pattern layer (170m) is formed by patterning on the interlayer insulating film (161). The hydrogen capture pattern layer (170m) can be made of an oxide semiconductor material. The oxide semiconductor material may include at least one of an IZO (InZnO)-based oxide semiconductor material having an In concentration of 50% or more relative to the total concentration of In and Zn, an IGO (InGaO)-based oxide semiconductor material having an In concentration of 70% or more relative to the total concentration of In and Ga, an IGZO (InGaZnO)-based oxide semiconductor material having an In concentration of 50% or more relative to the total concentration of In, Ga, and Zn, an ITO (InSnO)-based oxide semiconductor material having an In concentration of 80% or more relative to the total concentration of In and Sn, an IGZTO (InGaZnSnO)-based oxide semiconductor material having an sum of In and Sn concentrations of 45% or more relative to the total concentration of In, Ga, Zn, and Sn, and an ITZO (InSnZnO)-based oxide semiconductor material having an sum of In and Sn concentrations of 45% or more relative to the total concentration of In, Sn, and Zn.

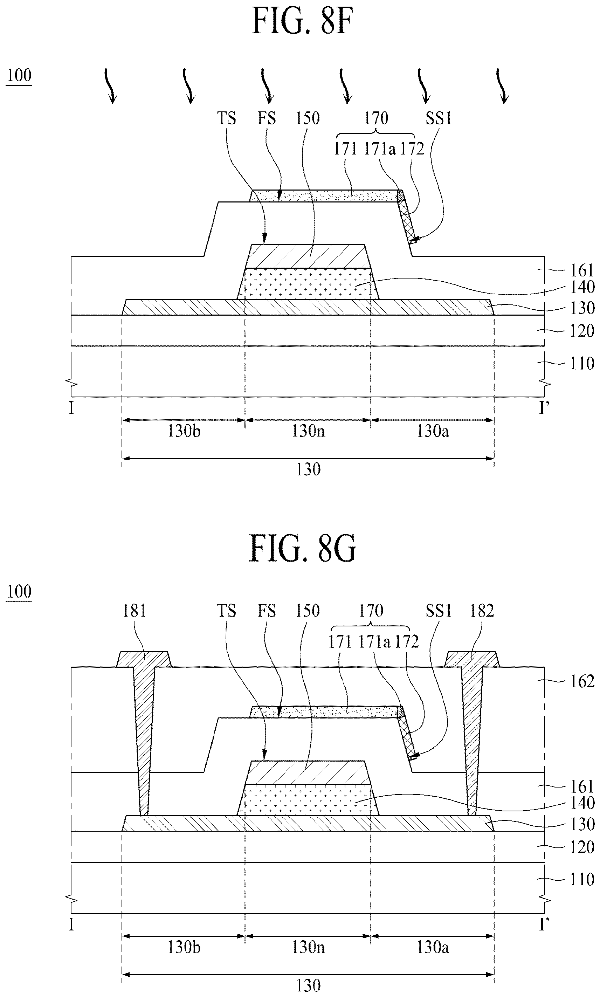

Referring to FIG. 8F, a heat treatment can be performed on a hydrogen capture pattern layer (170m) to form a hydrogen capture layer (170).

The hydrogen capture layer (170) includes a first hydrogen capture layer (171) and a second hydrogen capture layer (172). The thickness of the second hydrogen capture layer (172) may be 10% to 60% of the thickness of the first hydrogen capture layer (171).

When heat treatment is performed on the hydrogen capture pattern layer (170 m), the hydrogen capture pattern layer (170 m) disposed on the flat surface (FS) of the interlayer insulating film (161) has a thickness sufficient for crystallization to proceed and thus can have an excellent crystal structure.

On the other hand, the hydrogen capture pattern layer (170 m) disposed on the first inclined surface (SS1) of the interlayer insulating film (161) does not have a thickness sufficient for crystallization to proceed, and thus has an unstable crystal structure. In other words, the hydrogen capture capabilities of the first hydrogen capture layer (171) and the second hydrogen capture layer (172) can be differentiated.

The carrier concentration profile at the first connecting portion (130a) can be controlled by the second hydrogen capture layer (172) disposed on the first inclined surface (SS1).

Although the drawing illustrates a first hydrogen capture layer (171) and a second hydrogen capture layer (172) being disposed, the present invention is not limited thereto, and the hydrogen capture layer (170) may include a first hydrogen capture layer (171), a second hydrogen capture layer (172), and a third hydrogen capture layer (173).

At this time, the step of heat treating the hydrogen capture pattern layer (170 m) can be performed at a temperature of 300 to 400°C.

Referring to FIG. 8G, an insulating film (162) can be formed on a hydrogen capture layer (170), and a source electrode (181) and a drain electrode (182) can be formed on the insulating film (162).

The source electrode (181) and the drain electrode (182) are each connected to the active layer (130) through a contact hole. Specifically, the source electrode (181) and the drain electrode (182) are connected to the active layer (130) by contacting the second connecting portion (130b) and the first connecting portion (130a).

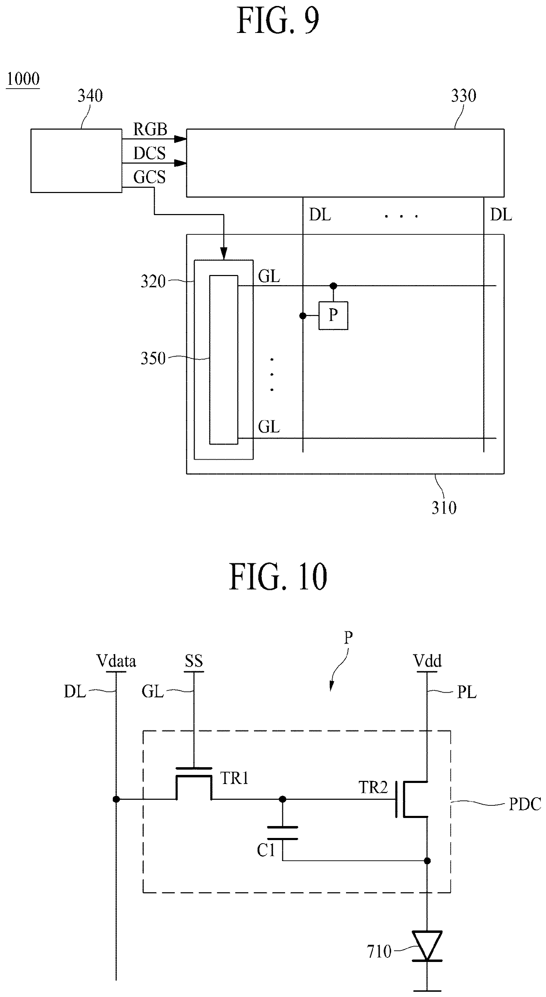

FIG. 9 is a schematic diagram illustrating a display apparatus 1000 according to further still another embodiment of the present disclosure.

As shown in FIG. 9, the display apparatus 1000 according to further still another embodiment of the present disclosure may include a display panel 310, a gate driver 320, a data driver 330 and a controller 340.

The display panel 310 includes gate lines GL and data lines DL, and pixels P are disposed in intersection areas of the gate lines GL and the data lines DL. An image is displayed by driving of the pixels P. The gate lines GL, the data lines DL and the pixels P may be disposed on the base substrate 110.

The controller 340 controls the gate driver 320 and the data driver 330.

The controller 340 outputs a gate control signal GCS for controlling the gate driver 320 and a data control signal DCS for controlling the data driver 330 by using a signal supplied from an external system not shown. Also, the controller 340 samples input image data input from the external system, realigns the sampled data and supplies the realigned digital image data RGB to the data driver 330.

The gate control signal GCS includes a gate start pulse GSP, a gate shift clock GSC, a gate output enable signal GOE, a start signal Vst and a gate clock GCLK. Also, control signals for controlling a shift register may be included in the gate control signal GCS.

The data control signal DCS includes a source start pulse SSP, a source shift clock signal SSC, a source output enable signal SOE and a polarity control signal POL.

The data driver 330 supplies a data voltage to the data lines DL of the display panel 310. In detail, the data driver 330 converts the image data RGB input from the controller 340 into an analog data voltage and supplies the data voltage to the data lines DL.

According to one embodiment of the present disclosure, the gate driver 320 may be packaged on the display panel 310. In this way, a structure in which the gate driver 320 is directly packaged on the display panel 310 will be referred to as a Gate In Panel (GIP) structure. In detail, in the Gate In Panel (GIP) structure, the gate driver 320 may be disposed on the base substrate 110.

The display apparatus 1000 according to one embodiment of the present disclosure may include the above-described thin film transistors 100, 200, 300 and 400. According to one embodiment of the present disclosure, the gate driver 320 may include a second thin film transistor (T2) of a thin film transistor substrate (500) according to FIG. 7.

The gate driver 320 may include a shift register 350.

The shift register 350 sequentially supplies gate pulses to the gate lines GL for one frame by using the start signal and the gate clock, which are transmitted from the controller 340. In this case, one frame means a time period at which one image is output through the display panel 310. The gate pulse has a turn-on voltage capable of turning on a switching device (thin film transistor) disposed in the pixel P.

Also, the shift register 350 supplies a gate-off signal capable of turning off the switching device, to the gate line GL for the other period of one frame, at which the gate pulse is not supplied. Hereinafter, the gate pulse and the gate-off signal will be collectively referred to as a scan signal SS or Scan.

The shift register 350 may include a second thin film transistor (T2) of a thin film transistor substrate (500) according to FIG. 7.

FIG. 10 is a circuit view illustrating any one pixel P of FIG. 9.

The circuit view of FIG. 10 is an equivalent circuit view for the pixel P of the display apparatus 1000 that includes an organic light emitting diode (OLED) as a display element 710.

Referring to FIG. 10, the pixel P includes a display element 710 and a pixel driving circuit PDC for driving the display element 710. In detail, the display apparatus 1000 according to one embodiment of the present disclosure may include a pixel driving circuit PDC on the base substrate 110.

The pixel driving circuit PDC of FIG. 10 includes a first thin film transistor TR1 that is a switching transistor and a second thin film transistor TR2 that is a driving transistor.

According to another embodiment of the present invention, the first thin film transistor (T1) of the thin film transistor substrate (500) described above may be used as the driving transistor of the pixel driving circuit (PDC) illustrated in FIG. 10. The second thin film transistor (T2) of the thin film transistor substrate (500) described above may also be used as the switching transistor of the pixel driving circuit (PDC) illustrated in FIG. 10.

According to another embodiment of the present invention, the thin film transistors (100, 200, 300, 400) described above can be used as the driving transistors of the pixel driving circuit (PDC) illustrated in FIG. 10.

Hereinafter, for convenience of explanation, the pixel driving circuit (PDC) of FIG. 10 will be described with a display apparatus (1000) centered on an embodiment in which the first thin film transistor (T1) of the thin film transistor substrate (500) described above is applied as a driving transistor and the second thin film transistor (T2) is applied as a switching transistor.

The first thin film transistor (TR1) is connected to the display element (710). The first thin film transistor (TR1) is connected to the gate line (GL) and the data line (DL), and is turned on or off by the scan signal (SS) supplied through the gate line (GL).

The data line (DL) provides data voltage (Vdata) to the pixel driver circuit (PDC) and the first thin film transistor(TR1) controls the application of data voltage (Vdata).

The driving power line (PL) provides a driving voltage (Vdd) to the display element (710), and the second thin film transistor (TR2) controls the application of the driving voltage (Vdd). The driving voltage (Vdd) is a pixel driving voltage for driving an organic light-emitting diode (OLED), which is the display element (710).

When the first thin film transistor (TR1) is turned on by a scan signal (SS) applied through the gate line (GL) from the gate driver (320), the data voltage (Vdata) supplied through the data line (DL) is supplied to the gate electrode of the second thin film transistor (TR2) connected to the display element (710). The data voltage (Vdata) is charged in the storage capacitor (C1) formed between the gate electrode and the source electrode of the second thin film transistor (TR2).

The amount of current supplied to the organic light-emitting diode (OLED), which is a display element (710), through the second thin film transistor (TR2) is controlled according to the data voltage (Vdata), and accordingly, the gradation of light output from the display element (710) can be controlled.

A pixel driving circuit (PDC) according to another embodiment of the present invention may be formed in various structures other than the structures described above. The pixel driving circuit (PDC) may include, for example, three or more thin film transistors.

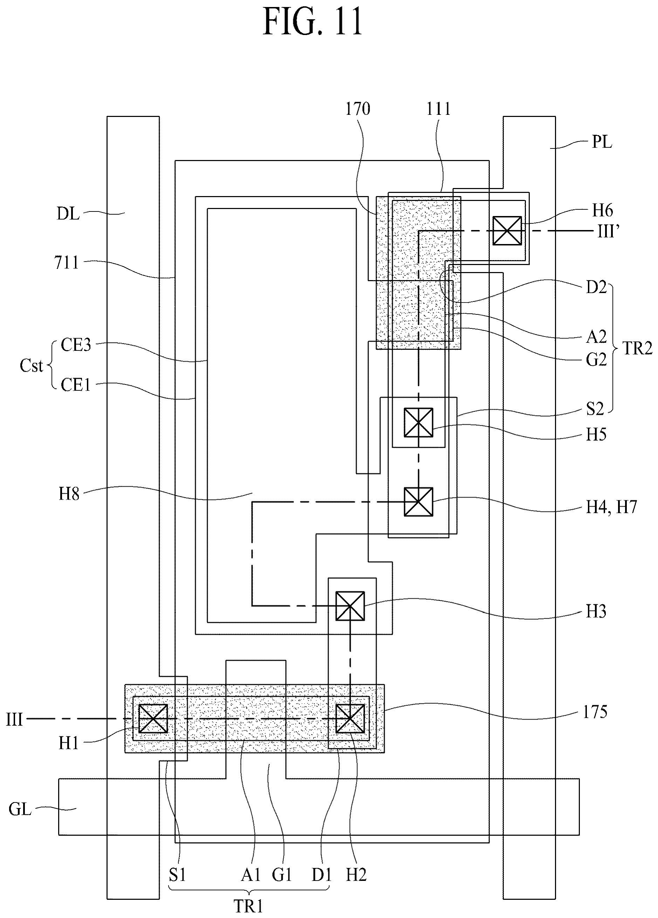

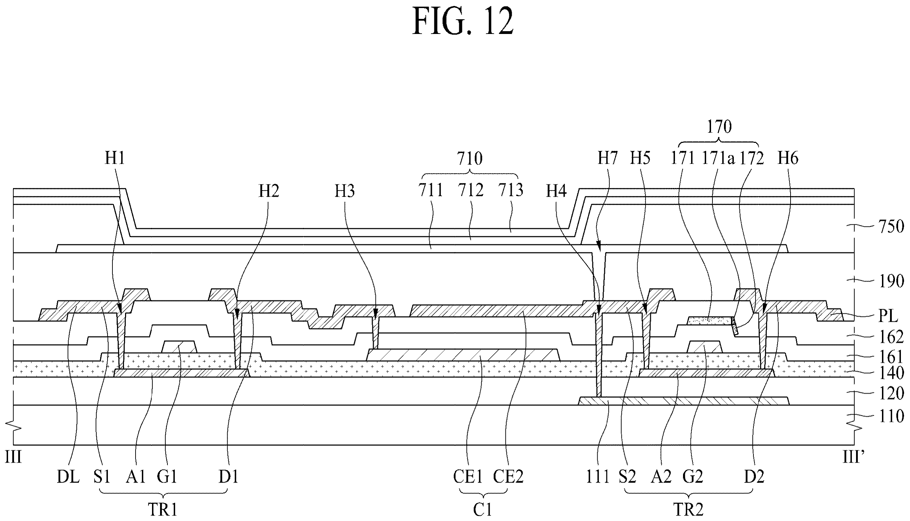

Fig. 11 is a plan view of the pixel of Fig. 10, and Fig. 12 is a cross-sectional view taken along line III-III' of Fig. 11.

Referring to Fig. 12, a light-blocking layer (111) is disposed on a base substrate (110).

The base substrate (110) may be made of glass or plastic. As the base substrate (110), a plastic having flexible properties, for example, polyimide (PI), may be used.

The light-blocking layer (111) can function as a light-blocking layer. The light-blocking layer (111) blocks light incident from the outside to protect the second active layer (A2) of the second thin film transistor (TR2).

Referring to Fig. 12, a buffer layer (120) may be disposed on a light-blocking layer (111). The buffer layer (120) is disposed to cover the entire upper surface of the base substrate (110). The buffer layer (120) is made of an insulating material and protects the active layers (A1, A2) from moisture or oxygen flowing in from the outside.

The active layer (A1) of the first thin film transistor (TR1) and the active layer (A2) of the second thin film transistor (TR2) can be disposed on the buffer layer (120).

The active layers (A1, A2) may include, for example, an oxide semiconductor material. The active layers (A1, A2) may be formed of an oxide semiconductor layer made of an oxide semiconductor material.

The active layers (A1, A2) of Fig. 12 may correspond to the second active layer (132) and the first active layer (131) illustrated in Fig. 7.

A gate insulating film (140) is disposed on the active layer (A1, A2). The gate insulating film (140) may cover the entire upper surface of the active layer (A1, A2) or may cover only a portion of the active layer (A1, A2).

A gate electrode (G1) of a first thin film transistor (TR1) and a gate electrode (G2) of a second thin film transistor (TR2) are disposed on a gate insulating film (140).

The gate electrode (G1) of the first thin film transistor (TR1) overlaps at least a portion of the active layer (A1). The gate electrode (G2) of the second thin film transistor (TR2) overlaps at least a portion of the active layer (A2).

Referring to Fig. 12, the first capacitor electrode (CE1) of the first capacitor (C1) may be disposed on the same layer as the gate electrodes (G1, G2). The gate electrodes (G1, G2) and the first capacitor electrode (CE1) may be manufactured together by the same process using the same material.

An interlayer insulating film (161) is disposed on the gate electrodes (G1, G2) and the first capacitor electrode (CE1).

A hydrogen capture layer (170) is disposed on the interlayer insulating film (161). The hydrogen capture layer (170) can overlap with the gate electrode (G2) of the second thin film transistor (TR2). The hydrogen capture layer (170) may include a first hydrogen capture layer (171) disposed on the flat surface of the interlayer insulating film (161) and a second hydrogen capture layer (172) disposed on the first inclined surface. In addition, the hydrogen capture layer (170) may further include a first intermediate layer (171a) disposed between the first hydrogen capture layer (171) and the second hydrogen capture layer (172).

An insulating film (162) is disposed on the interlayer insulating film (161).The insulating film (162) may include silicon nitride (SiNx). The insulating film (162) may be one layer or multiple layers.

Source electrodes (S1, S2) and drain electrodes (D1, D2) are disposed on an insulating film (162). According to one embodiment of the present invention, the source electrodes (S1, S2) and the drain electrodes (D1, D2) are distinguished only for convenience of explanation, and the source electrodes (S1, S2) and the drain electrodes (D1, D2) may be interchanged.

In addition, a data line (DL) and a driving power line (PL) are disposed on the insulating film (162). The source electrode (S1) of the first thin film transistor (TR1) may be formed integrally with the data line (DL). The drain electrode (D2) of the second thin film transistor (TR2) may be formed integrally with the driving power line (PL).

According to one embodiment of the present invention, the source electrode (S1) and the drain electrode (D1) of the first thin film transistor (TR1) are spaced apart from each other and are respectively connected to the active layer (A1) of the first thin film transistor (TR1). The source electrode (S2) and the drain electrode (D2) of the second thin film transistor (TR2) are spaced apart from each other and are respectively connected to the active layer (A2) of the second thin film transistor (TR2).

The source electrode (S1) of the first thin film transistor (TR1) can contact the source region of the active layer (A1) through the first contact hole (H1).

The drain electrode (D1) of the first thin film transistor (TR1) can be in contact with the drain region of the active layer (A1) through the second contact hole (H2) and connected to the first capacitor electrode (CE1) of the first capacitor (C1) through the third contact hole (H3).

The source electrode (S2) of the second thin film transistor (TR2) extends over the insulating film (162) so that a portion thereof can serve as the second capacitor electrode (CE2) of the first capacitor (C1). The first capacitor electrode (CE1) and the second capacitor electrode (CE2) overlap to form the first capacitor (C1).

Additionally, the source electrode (S2) of the second thin film transistor (TR2) can contact the light blocking layer (111) through the fourth contact hole (H4).

The source electrode (S2) of the second thin film transistor (TR2) can contact the source region of the active layer (A2) through the fifth contact hole (H5).

The drain electrode (D2) of the second thin film transistor (TR2) can contact the drain region of the active layer (A2) through the sixth contact hole (H6).

The first thin film transistor (TR1) includes an active layer (A1), a gate electrode (G1), a source electrode (S1), and a drain electrode (D1), and acts as a switching transistor that controls a data voltage (Vdata) applied to a pixel driving circuit (PDC).

The second thin film transistor (TR2) includes an active layer (A2), a gate electrode (G2), a source electrode (S2), and a drain electrode (D2), and acts as a driving transistor that controls the driving voltage (Vdd) applied to the display element (710).

A planarization layer (190) is disposed on the source electrodes (S1, S2), the drain electrodes (D1, D2), the data line (DL), and the driving power line (PL). The planarization layer (190) planarizes the upper portions of the first thin film transistor (TR1) and the second thin film transistor (TR2), and protects the first thin film transistor (TR1) and the second thin film transistor (TR2).

A first electrode (711) of a display element (710) is disposed on a planarization layer (190). The first electrode (711) of the display element (710) can be connected to a source electrode (S2) of a second thin film transistor (TR2) through a seventh contact hole (H7) formed in the planarization layer (190).

A bank layer (750) is disposed at the edge of the first electrode (711). The bank layer (750) defines a light-emitting area of the display element (710).

An organic light-emitting layer (712) is disposed on a first electrode (711), and a second electrode (713) is disposed on the organic light-emitting layer (712). Accordingly, a display element (710) is completed. The display element (710) illustrated in FIG. 11 is an organic light-emitting diode (OLED). Therefore, a display apparatus (1000) according to an embodiment of the present invention is an organic light-emitting display device.

As described above, the thin film transistors (100, 200, 300, 400) of the present invention can be applied to the second thin film transistor (TR2), which is a driving transistor included in a pixel driving circuit (PDC) of a display apparatus requiring excellent gray scale representation capability.

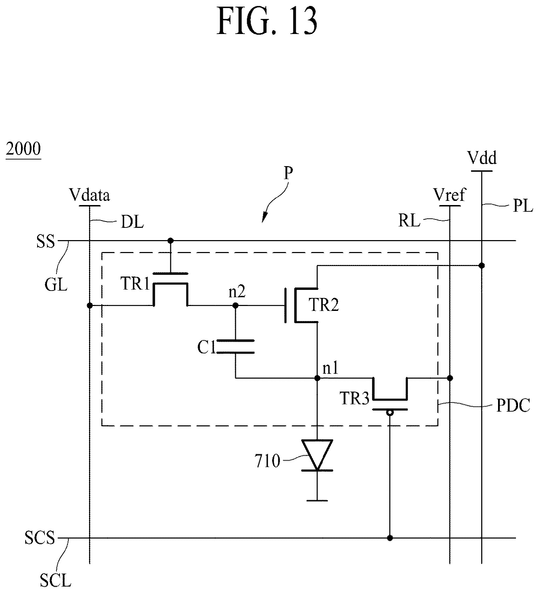

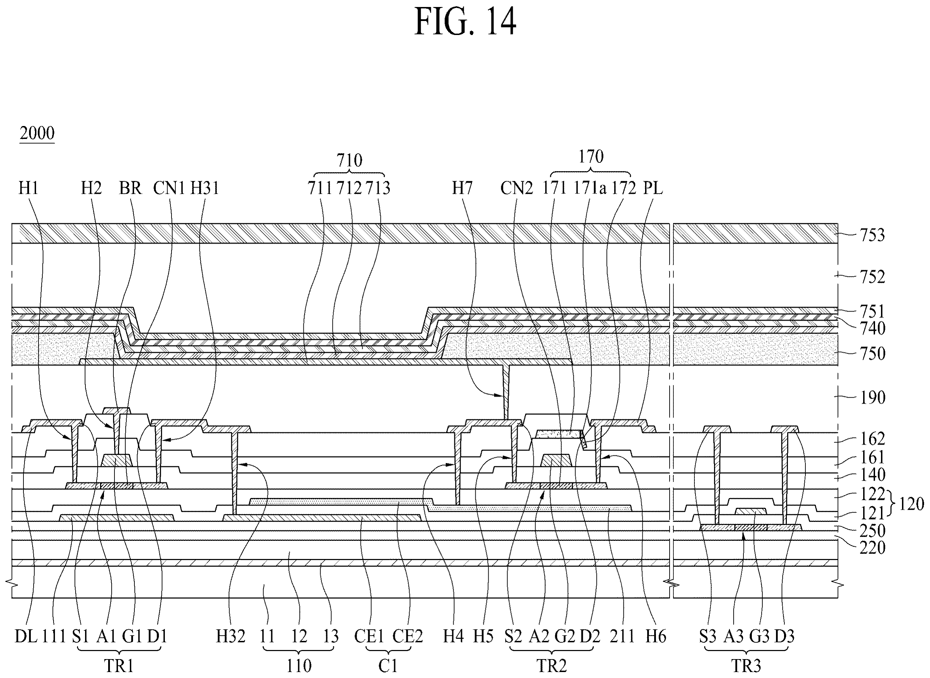

FIG. 13 is a circuit diagram of one pixel (P) of a display apparatus (2000) according to another embodiment of the present invention, and FIG. 14 is a cross-sectional view of a part of the pixel (P) shown in FIG. 13. Hereinafter, in order to avoid redundancy, components already described will be briefly explained or their description will be omitted.

FIG. 13 is an equivalent circuit diagram of the pixel (P) of the organic light emitting display device. Signal lines (DL, GL, PL, RL, SCL) for supplying signals to a pixel driving circuit (PDC) are disposed in the pixel (P). A data voltage (Vdata) is supplied through the data line (DL), a scan signal (SS) is supplied through the gate line (GL), a driving voltage (Vdd) for driving the display element (710) is supplied through the driving power line (PL), a reference voltage (Vref) is supplied through the reference line (RL), and a sensing control signal (SCS) is supplied through the sensing control line (SCL).

The pixel driving circuit (PDC) of FIG. 13 may further include a third thin film transistor (TR3) for sensing characteristics of the second thin film transistor (TR2), in comparison with the pixel driving circuit (PDC) of FIG. 11. The third thin film transistor (TR3) may also be referred to as a reference transistor. The third thin film transistor (TR3) is connected between a first node (n1) disposed between the second thin film transistor (TR2) and the display element (710), and the reference line (RL), and is turned on or off by the sensing control signal (SCS) so as to sense the characteristics of the second thin film transistor (TR2) during a sensing period.

A second node (n2) connected to the gate electrode of the second thin film transistor (TR2) is connected to the first thin film transistor (TR1). A first capacitor (C1) is formed between the second node (n2) and the first node (n1).

When the first thin film transistor (TR1) is turned on, the data voltage (Vdata) supplied through the data line (DL) is provided to the gate electrode of the second thin film transistor (TR2). The data voltage (Vdata) is charged to the first capacitor (C1) formed between the gate electrode and the source electrode of the second thin film transistor (TR2).

When the second thin film transistor (TR2) is turned on, current is supplied to the display element (710) through the second thin film transistor (TR2) by the driving voltage (Vdd), thereby emitting light from the display element (710).

Referring to FIG. 14, an example is illustrated in which the third active layer (A3) of the third thin film transistor (TR3) is disposed on a layer different from the active layers (A1, A2) of the other thin film transistors (TR1, TR2). In addition, the third gate electrode (G3) of the third thin film transistor (TR3) may be disposed on a layer different from the gate electrodes (G1, G2) of the other thin film transistors (TR1, TR2). According to the present invention, the third thin film transistor (TR3) may be referred to as the lower thin film transistor.

The third active layer (A3) of the third thin film transistor (TR3) may be disposed on a layer different from the first active layer (A1) of the first thin film transistor (TR1). Each of the active layers (A1, A3) may include the same type of semiconductor material, or may include different types of semiconductor materials. Each of the active layers (A1, A3) may include, for example, an oxide semiconductor material. Alternatively, the first active layer (A1) of the first thin film transistor (TR1) may include an oxide semiconductor, and the third active layer (A3) of the third thin film transistor (TR3) may include a silicon semiconductor. Specifically, the third active layer (A3) may include a low-temperature polycrystalline silicon semiconductor material.

Referring to FIG. 14, the first thin film transistor (TR1), the second thin film transistor (TR2), and the third thin film transistor (TR3) are disposed on a base substrate (110). The base substrate (110) may include, for example, a first layer (11), an intermediate layer (13), and a second layer (12). The first layer (11) and the second layer (12) may each include polyimide (PI). The intermediate layer (13) may function as an adhesive layer that bonds the first layer (11) and the second layer (12).

Referring to FIG. 14, a buffer insulating layer (220) is disposed on the base substrate (110), and a third active layer (A3) is disposed on the buffer insulating layer (220). The third active layer (A3) may include a silicon semiconductor. However, the present invention is not limited thereto, and according to another embodiment of the present invention, the third active layer (A3) may include an oxide semiconductor.

A lower gate insulating layer (250) is disposed on the third active layer (A3). A first light-blocking layer (111), a first capacitor electrode (CE1), and a third gate electrode (G3) are disposed on the lower gate insulating layer (250). The first light-blocking layer (111), the first capacitor electrode (CE1), and the third gate electrode (G3) may be disposed on the same layer and may be formed of the same material.

A first buffer layer (121) may be disposed on the first light-blocking layer (111), the first capacitor electrode (CE1), and the third gate electrode (G3). A second light-blocking layer (211) and a second capacitor electrode (CE2) may be disposed on the first buffer layer (121).

The second light-blocking layer (211) and the second capacitor electrode (CE2) may be formed integrally with each other, and may be formed of the same material through the same process.

The first capacitor (C1) is formed by overlapping the first capacitor electrode (CE1) and the second capacitor electrode (CE2).

Referring to FIG. 14, a second buffer layer (122) is disposed on the second light-blocking layer (211) and the second capacitor electrode (CE2). The buffer layer (120) may include the first buffer layer (121) and the second buffer layer (122) disposed on the first buffer layer (121).

Active layers (A1, A2) are disposed on the buffer layer (120). The active layers (A1, A2) may include the first active layer (A1) of the first thin film transistor (TR1) and the second active layer (A2) of the second thin film transistor (TR2). The first active layer (A1) may include a first channel portion (CN1) overlapping the gate electrode (G1) of the first thin film transistor (TR1). The second active layer (A2) may include a second channel portion (CN2) overlapping the gate electrode (G2) of the second thin film transistor (TR2). The active layers (A1, A2) may include, for example, an oxide semiconductor material. The description of the active layers (A1, A2) is the same as previously described and may be omitted.

A gate insulating film (140) is disposed on the active layers (A1, A2). The description of the gate insulating film (140) is the same as previously described and may be omitted.

Gate electrodes (G1, G2) are disposed on the gate insulating film (140).

An interlayer insulating film (161) is disposed on the gate electrodes (G1, G2). A hydrogen capture layer (170) is disposed on the interlayer insulating film (161). The hydrogen capture layer (170) can overlap with the gate electrode (G2) of the second thin film transistor (TR2). The hydrogen capture layer (170) may include a first hydrogen capture layer (171) disposed on the flat surface of the interlayer insulating film (161) and a second hydrogen capture layer (172) disposed on the first inclined surface. In addition, the hydrogen capture layer (170) may further include a first intermediate layer (171a) disposed between the first hydrogen capture layer (171) and the second hydrogen capture layer (172).

An insulating film (162) is disposed on the interlayer insulating film (161). The insulating film (162) may include silicon nitride (SiNx).

Source electrodes (S1, S2, S3) and drain electrodes (D1, D2, D3) are disposed on the insulating film (162).

In addition, a data line (DL) and a driving power line (PL) may be disposed on the insulating film (162), and a connection electrode (BR) may also be disposed on the insulating film (162).

The first source electrode (S1) of the first thin film transistor (TR1) is connected to the first active layer (A1) through the first contact hole (H1).

The first gate electrode (G1) may be connected to the first light-blocking layer (111) through a connection electrode (BR). Specifically, the connection electrode (BR) may be connected to the first gate electrode (G1) through a second contact hole (H2), and connected to the first light-blocking layer (111) through another contact hole (not shown). As a result, the connection electrode (BR) electrically connects the first gate electrode (G1) and the first light-blocking layer (111).

The first light-blocking layer (111) may be applied with the same voltage as the first gate electrode (G1). Accordingly, the first light-blocking layer (111) may serve as a gate electrode of the first thin film transistor (TR1).

The first drain electrode (D1) is connected to the first active layer (A1) through one contact hole (H31) and may be connected to the first capacitor electrode (CE1) through another contact hole (H32).

The source electrode (S2) of the second thin film transistor (TR2) is connected to the second light-blocking layer (211) through the fourth contact hole (H4) and is connected to the second active layer (A2) through the fifth contact hole (H5).

Since the second light-blocking layer (211) is connected to the second capacitor electrode (CE2), the same voltage as that of the source electrode (S2) of the second thin film transistor (TR2) can be applied to the second capacitor electrode (CE2).

The second drain electrode (D2) of the second thin film transistor (TR2) is connected to the second active layer (A2) through the sixth contact hole (H6).

The third source electrode (S3) and the third drain electrode (D3) are disposed on the insulating film (162) and may be respectively connected to the third active layer (A3) through respective contact holes.

The first thin film transistor (TR1) includes the first active layer (A1), the first gate electrode (G1), the first source electrode (S1), and the first drain electrode (D1), and serves as a switching transistor for controlling a data voltage (Vdata) applied to the pixel driving circuit (PDC).

The second thin film transistor (TR2) includes the second active layer (A2), the second gate electrode (G2), the second source electrode (S2), and the second drain electrode (D2), and serves as a driving transistor for controlling the driving voltage (Vdd) applied to the display element (710).

The third thin film transistor (TR3) may be formed by the third active layer (A3), the third gate electrode (G3), the third source electrode (S3), and the third drain electrode (D3).

A planarization layer (190) is disposed on the source electrodes (S1, S2, S3), the drain electrodes (D1, D2, D3), the connection electrode (BR1), the data line (DL), and the driving power line (PL). The planarization layer (190) planarizes the upper portions of the first thin film transistor (TR1), the second thin film transistor (TR2), and the third thin film transistor (TR3).

A first electrode (711), an organic light-emitting layer (712), a second electrode (713) of the display element (710), and a bank layer (750) are disposed on the planarization layer (180). The descriptions of the first electrode (711), the organic light-emitting layer (712), the second electrode (713), and the bank layer (750) are the same as previously described and may be omitted.

A capping layer (740) may be disposed on the second electrode (713). The capping layer (740) protects the display element (710) and may be formed of an insulating material.

A first passivation layer (751) is disposed on the capping layer (740). The first passivation layer (751) protects the upper portion of the display element (710) and can prevent moisture or oxygen from penetrating into the display element (710).

A particle cover layer (PCL) (752) is disposed on the first passivation layer (751). The particle cover layer (752) prevents unevenness from occurring on the surface of the display apparatus (2000) due to particles generated during a manufacturing process of the display apparatus (2000).

The particle cover layer (752) may include an organic material. The particle cover layer (752) may be formed of, for example, a polymer material.

A second passivation layer (753) may be disposed on the particle cover layer (752). The second passivation layer (753) can prevent or suppress penetration of moisture or oxygen.

According to one embodiment of the present invention, the first passivation layer (751), the particle cover layer (752), and the second passivation layer (753) may be referred to as an encapsulation layer.

Referring to FIG. 14, in a case where the pixel driving circuit (PDC) of the display apparatus requires excellent gray scale representation characteristics, the thin film transistor (100, 200, 300, 400) of the present invention can be applied to the second thin film transistor (TR2), which is a driving transistor included in the pixel driving circuit (PDC) of the display element (710).

In general, as products become more advanced and structures become more complex, the amount of hydrogen introduced into the thin film transistor (TFT) tends to increase due to factors such as an increase in the thickness of upper and lower insulating films or inclined insulating films. When the inflow of hydrogen increases, in the case of an oxide semiconductor device, there may occur a problem in that the threshold voltage shifts in a negative direction and the device characteristics deteriorate. Therefore, in order to secure process margin and improve device reliability, a hydrogen capture structure capable of effectively suppressing hydrogen inflow from the upper or inclined insulating films is required.

Referring to FIG. 14, the second thin film transistor (TR2) including the oxide semiconductor material-containing active layer (A2) may further include a hydrogen capture layer (170) in order to suppress hydrogen introduced from the buffer insulating layer (220), the lower gate insulating layer (250), the first buffer layer (121), the second buffer layer (122), the gate insulating film (140), the interlayer insulating film (161), the insulating film (162) and the planarization layer (190) disposed around the second thin film transistor (TR2). For example, the buffer insulating layer (220), the lower gate insulating layer (250), the first buffer layer (121), the second buffer layer (122), the gate insulating film (140), the interlayer insulating film (161), and the planarization layer (190) may each include silicon nitride (SiNₓ).

In particular, although not illustrated in the drawing, in a case where a hole-inactive-area (HiAA) structure, in which a hole is formed in the display area and an electronic device is disposed under the hole, is applied to the display device, a thick insulating layer may be stacked in the HiAA region. Accordingly, in order to suppress hydrogen introduced from the thick insulating layer stacked in the HiAA region, the thin film transistors (100, 200, 300, 400) of the present invention may include the hydrogen capture layer (170).

According to another embodiment of the present invention, the pixel driving circuit (PDC) may be formed in various structures other than the structures described above. For example, the pixel driving circuit (PDC) may include four or more thin film transistors, and may also include two or more capacitors.

According to the present disclosure, the following advantageous effects may be obtained.

A thin film transistor according to one embodiment of the present invention can suppress hydrogen flowing in from above by including a hydrogen capture layer disposed on an upper portion of an active layer.

A thin film transistor according to another embodiment of the present invention can improve HCS (Hot Carrier Stress) reliability by including a hydrogen capture layer having different crystallinity in each region.

A thin film transistor substrate according to another embodiment of the present invention can simultaneously improve the device characteristics of a driving transistor and a switching transistor.

In addition to the effects mentioned above, other features and advantages of the present invention are described below or may be clearly understood by those skilled in the art to which the present invention pertains from such description and explanation.

It will be apparent to those skilled in the art that the present disclosure described above is not limited by the above-described embodiments and the accompanying drawings and that various substitutions, modifications and variations can be made in the present disclosure without departing from the scope of the disclosures. Consequently, the scope of the present disclosure is defined by the accompanying claims and it is intended that all variations or modifications derived from the meaning, scope and equivalent concept of the claims fall within the scope of the present disclosure.

Also disclosed herein are the following numbered clauses:
1. A display apparatus comprising:
   a gate driver and a pixel driving circuit on a base substrate;
   wherein the pixel driving circuit includes a driving transistor;
   wherein the driving transistor includes a thin film transistor, the thin film transistor comprising:
      an active layer;
      a gate electrode disposed on the active layer and overlapping the active layer;
      an interlayer insulating film on the gate electrode; and
      a hydrogen-capture layer on the interlayer insulating film,
      wherein the interlayer insulating film includes a flat surface parallel to an upper surface of the gate electrode and a first inclined surface disposed on one side of the flat surface and having a constant slope with respect to the flat surface,
      wherein the hydrogen-capture layer includes a first hydrogen-capture layer disposed on the flat surface and a second hydrogen-capture layer disposed on the first inclined surface, and
      wherein the first hydrogen-capture layer and the second hydrogen-capture layer have different crystal structures.
2. The display apparatus of clause 1, wherein the first hydrogen capture layer has a first crystal grain having a particle size of 1 nm or greater,
   wherein the first crystal grain account for 80% or greater of the total cross-sectional area of the first hydrogen capture layer,
   wherein the second hydrogen capture layer has a second crystal grain having a particle size of 1 nm or greater, and
   wherein the second crystal grain account for 70% or less of the total cross-sectional area of the second hydrogen capture layer.
3. The display apparatus of clause 1 or 2, wherein the hydrogen capture layer of the thin film transistor is made of an oxide semiconductor material, and optionally
   wherein the oxide semiconductor material includes at least one of an IZO (InZnO)-based oxide semiconductor material having an In concentration of 50% or more relative to the total concentration of In and Zn, an IGO (InGaO)-based oxide semiconductor material having an In concentration of 70% or more relative to the total concentration of In and Ga, an IGZO (InGaZnO)-based oxide semiconductor material having an In concentration of 50% or more relative to the total concentration of In, Ga, and Zn, an ITO (InSnO)-based oxide semiconductor material having an In concentration of 80% or more relative to the total concentration of In and Sn, an IGZTO (InGaZnSnO)-based oxide semiconductor material having an sum of In and Sn concentrations of 45% or more relative to the total concentration of In, Ga, Zn, and Sn, and an ITZO (InSnZnO)-based oxide semiconductor material having an sum of In and Sn concentrations of 45% or more relative to the total concentration of In, Sn, and Zn.
4. The display apparatus of clause 3 when the oxide semiconductor material includes an IZO (InZnO)-based oxide semiconductor material having an In concentration of 50% or more relative to the total concentration of In and Zn, and wherein the ratio of In and Zn is between 5:5 and 7:3, and preferably wherein the ratio is 5:5, 6:4, 7:3.
5. The display apparatus of clause 3 when the oxide semiconductor layer includes an IGO (InGaO)-based oxide semiconductor material having an In concentration of 70% or more relative to the total concentration of In and Ga, and the ratio of In and Ga is between 7:3 and 9:1, and preferably wherein the ratio is 7:3, 8:2, 9:1.
6. The display apparatus of any preceding clause, wherein the first hydrogen capture layer overlaps the gate electrode, the second hydrogen capture layer does not overlap the gate electrode, and
   wherein the flat surface overlaps the gate electrode, and the first inclined surface does not overlap the gate electrode.
7. The display apparatus of any preceding clause, the active layer includes:
   a channel portion;
   a first connecting portion disposed on one side of the channel portion and overlapping the first inclined surface; and
   a second connecting portion disposed on the other side of the channel portion.
8. The display apparatus of any preceding clause wherein a carrier concentration of the second hydrogen capture layer has a slope that becomes more gentle from the first connecting portion to the channel portion.
9. The display apparatus of clause 7 or 8 wherein the first connecting portion and the second connecting portion do not overlap with the gate electrode.
10. The display apparatus of any preceding clause, wherein the thickness of the second hydrogen capture layer is 10% to 60% of thickness of the first hydrogen capture layer.
11. The display apparatus of any preceding clause, wherein the hydrogen capture layer of the thin film transistor further includes a first intermediate layer disposed between the first hydrogen capture layer and the second hydrogen capture layer, and
   wherein the first intermediate layer is disposed adjacent to an end of the flat surface and an end of the first inclined surface.
12. The display apparatus of any preceding clause, wherein the first inclined surface has a taper angle of 10 to 60° with respect to the flat surface.
13. The display apparatus of any preceding clause, further including an insulating film on the hydrogen capture layer of the thin film transistor that includes silicon nitride (SiNx).
14. The display apparatus of any preceding clause, wherein the interlayer insulating film further includes a second inclined surface disposed on the other side of the flat surface and having a constant slope with respect to the flat surface,
   wherein the hydrogen capture layer of the thin film transistor further includes a third hydrogen capture layer disposed on the second inclined surface, and
   wherein the third hydrogen capture layer has a same crystal structure as the second hydrogen capture layer.
15. The display apparatus of clause 14, wherein the third hydrogen capture layer does not overlap the gate electrode, and the second inclined surface does not overlap the gate electrode.
16. The display apparatus of any preceding claim, further includes a gate insulating film disposed between the active layer and the gate electrode, wherein the gate insulating film exposes a portion of the active layer.
17. The display apparatus of any preceding clause, further includes a gate insulating film disposed between the active layer and the gate electrode, wherein the gate insulating film covers an entire upper surface of the active layer.
18. The display apparatus of any preceding clause,
   wherein the pixel driving circuit further includes a lower thin film transistor disposed apart from the thin film transistor,
   wherein the lower thin film transistor comprises an active layer and a gate electrode spaced apart from the active layer,
   wherein the active layer of the thin film transistor comprises an oxide semiconductor material, and
   wherein the active layer of the lower thin film transistor comprises a low-temperature polycrystalline silicon semiconductor material.
19. The display apparatus of clause 18,
   wherein the active layer of the lower thin film transistor is disposed below the active layer of the thin film transistor,
   wherein a plurality of insulating films are disposed between the active layer of the lower thin film transistor and the hydrogen-capture layer of the thin film transistor, and
   wherein each of the plurality of insulating films comprises silicon nitride (SiNx).
20. A display apparatus according to clause 1wherein:
   the thin film transistor is a first thin film transistor; and the display apparatus further comprises a second thin film transistor on the first thin film transistor,
   and further wherein the active layer is a first active layer;
   the first thin film transistor further comprises a first gate insulating film on the first active layer;
   the gate electrode is a first gate electrode disposed on the first gate insulating film and overlapping the first active layer;
   the interlayer insulating film is a first interlayer insulating film on the first gate electrode; and
   the hydrogen capture layer is a lower hydrogen-capture layer on the first interlayer insulating film,
   wherein the second thin film transistor comprises:
      a second active layer;
      a second gate insulating film on the second active layer;
      a second gate electrode disposed on the second gate insulating film and overlapping the second active layer;
      a second interlayer insulating film on the second gate electrode; and
      an upper hydrogen capture layer on the second interlayer insulating film,
      wherein the first interlayer insulating film includes a first flat surface parallel to an upper surface of the first gate electrode and a first-first inclined surface disposed on one side of the first flat surface and having a constant slope with respect to the first flat surface,
      wherein the second interlayer insulating film includes a second flat surface parallel to an upper surface of the second gate electrode and a second-first inclined surface disposed on one side of the second flat surface and having a constant slope with respect to the second flat surface,
      wherein the first gate insulating film exposes a part of the upper surface of the first active layer,
      wherein the second gate insulating film covers an entire upper surface of the second active layer,
      wherein the lower hydrogen capture layer includes a first-first hydrogen capture layer disposed on the first flat surface and a first-second hydrogen capture layer disposed on the first-first inclined surface, and
      wherein the upper hydrogen capture layer includes a second-first hydrogen capture layer disposed on the second flat surface and a second-second hydrogen capture layer disposed on the second-first inclined surface,
      wherein the first-first hydrogen-capture layer and the first-second hydrogen-capture layer have different crystal structures, and the second-first hydrogen-capture layer and the second-second hydrogen-capture layer have different crystal structures.
21. The display apparatus of clause 20, wherein a length of the first-first inclined surface is longer than a length of the second-first inclined surface, and a length of the first-second hydrogen capture layer is longer than a length of the second-second hydrogen capture layer.
22. The display apparatus of clause 20 or 21, wherein the first-second hydrogen capture layer does not overlap with the first gate insulating film, and the second-second hydrogen capture layer overlaps with the second gate insulating film.
23. A method for manufacturing a display apparatus, comprising:
   forming an active layer;
   sequentially forming a gate insulating film and a gate electrode on the active layer;
   forming an interlayer insulating film on the gate electrode;
   forming a hydrogen-capture pattern layer on the interlayer insulating film; and
   heat-treating the hydrogen-capture pattern layer to form a hydrogen-capture layer,
   wherein the interlayer insulating film includes a flat surface parallel to an upper surface of the gate electrode and a first inclined surface disposed on one side of the flat surface and having a constant slope with respect to the flat surface,
   wherein the hydrogen-capture layer includes a first hydrogen-capture layer disposed on the flat surface and a second hydrogen-capture layer disposed on the first inclined surface, and
   wherein the first hydrogen-capture layer and the second hydrogen-capture layer have different crystal structures.
24. The method for manufacturing a display apparatus of clause 23 further comprising manufacturing a display apparatus of any of clauses 2 to 22.
25. The method for manufacturing a thin film transistor of clause 23, wherein heat treating the hydrogen capture pattern layer is performed at a temperature of 300 to 400°C.

## Claims

1. A display apparatus comprising:
a gate driver and a pixel driving circuit on a base substrate;
wherein the pixel driving circuit includes a driving transistor;
wherein the driving transistor includes a thin film transistor, the thin film transistor comprising:
an active layer (130);
a gate electrode (150) disposed on the active layer and overlapping the active layer;
an interlayer insulating film (161) on the gate electrode; and
a hydrogen-capture layer (170) on the interlayer insulating film,
wherein the interlayer insulating film includes a flat surface parallel to an upper surface of the gate electrode and a first inclined surface disposed on one side of the flat surface and having a constant slope with respect to the flat surface,
wherein the hydrogen-capture layer (171) includes a first hydrogen-capture layer disposed on the flat surface and a second hydrogen-capture layer (172) disposed on the first inclined surface, and
wherein the first hydrogen-capture layer and the second hydrogen-capture layer have different crystal structures.

2. The display apparatus of claim 1, wherein the first hydrogen capture layer has a first crystal grain having a particle size of 1 nm or greater,
wherein the first crystal grain account for 80% or greater of the total cross-sectional area of the first hydrogen capture layer,
wherein the second hydrogen capture layer has a second crystal grain having a particle size of 1 nm or greater, and
wherein the second crystal grain account for 70% or less of the total cross-sectional area of the second hydrogen capture layer.

3. The display apparatus of claim 1 or 2, wherein the hydrogen capture layer of the thin film transistor is made of an oxide semiconductor material, and optionally
wherein the oxide semiconductor material includes at least one of an IZO (InZnO)-based oxide semiconductor material having an In concentration of 50% or more relative to the total concentration of In and Zn, an IGO (InGaO)-based oxide semiconductor material having an In concentration of 70% or more relative to the total concentration of In and Ga, an IGZO (InGaZnO)-based oxide semiconductor material having an In concentration of 50% or more relative to the total concentration of In, Ga, and Zn, an ITO (InSnO)-based oxide semiconductor material having an In concentration of 80% or more relative to the total concentration of In and Sn, an IGZTO (InGaZnSnO)-based oxide semiconductor material having an sum of In and Sn concentrations of 45% or more relative to the total concentration of In, Ga, Zn, and Sn, and an ITZO (InSnZnO)-based oxide semiconductor material having an sum of In and Sn concentrations of 45% or more relative to the total concentration of In, Sn, and Zn.

4. The display apparatus of claim 3 when the oxide semiconductor material includes an IZO (InZnO)-based oxide semiconductor material having an In concentration of 50% or more relative to the total concentration of In and Zn, and wherein the ratio of In and Zn is between 5:5 and 7:3, and preferably wherein the ratio is 5:5, 6:4, 7:3; or
when the oxide semiconductor layer includes an IGO (InGaO)-based oxide semiconductor material having an In concentration of 70% or more relative to the total concentration of In and Ga, and the ratio of In and Ga is between 7:3 and 9:1, and preferably wherein the ratio is 7:3, 8:2, 9:1.

5. The display apparatus of any preceding claim, wherein the first hydrogen capture layer overlaps the gate electrode, the second hydrogen capture layer does not overlap the gate electrode, and
wherein the flat surface overlaps the gate electrode, and the first inclined surface does not overlap the gate electrode.

6. The display apparatus of any preceding claim, the active layer includes:
a channel portion;
a first connecting portion disposed on one side of the channel portion and overlapping the first inclined surface; and
a second connecting portion disposed on the other side of the channel portion; and optionally
wherein the first connecting portion (130a) and the second connecting portion (130b) do not overlap with the gate electrode (150).

7. The display apparatus of any preceding claim wherein a carrier concentration of the second hydrogen capture layer has a slope that becomes more gentle from the first connecting portion to the channel portion; and optionally
wherein the first connecting portion (130a) and the second connecting portion (130b) do not overlap with the gate electrode (150).

8. The display apparatus of any preceding claim, wherein the thickness of the second hydrogen capture layer is 10% to 60% of thickness of the first hydrogen capture layer; and/or wherein the hydrogen capture layer of the thin film transistor further includes a first intermediate layer disposed between the first hydrogen capture layer and the second hydrogen capture layer, and
wherein the first intermediate layer is disposed adjacent to an end of the flat surface and an end of the first inclined surface.

9. The display apparatus of any preceding claim, wherein the first inclined surface has a taper angle of 10 to 60° with respect to the flat surface; or the display apparatus further including an insulating film on the hydrogen capture layer of the thin film transistor that includes silicon nitride (SiNx).

10. The display apparatus of any preceding claim, wherein the interlayer insulating film further includes a second inclined surface disposed on the other side of the flat surface and having a constant slope with respect to the flat surface,
wherein the hydrogen capture layer of the thin film transistor further includes a third hydrogen capture layer disposed on the second inclined surface, and
wherein the third hydrogen capture layer has a same crystal structure as the second hydrogen capture layer; and optionally wherein
the third hydrogen capture layer does not overlap the gate electrode, and the second inclined surface does not overlap the gate electrode.

11. The display apparatus of any preceding claim,
wherein the pixel driving circuit further includes a lower thin film transistor disposed apart from the thin film transistor,
wherein the lower thin film transistor comprises an active layer and a gate electrode spaced apart from the active layer,
wherein the active layer of the thin film transistor comprises an oxide semiconductor material, and
wherein the active layer of the lower thin film transistor comprises a low-temperature polycrystalline silicon semiconductor material; and optionally
wherein the active layer of the lower thin film transistor is disposed below the active layer of the thin film transistor,
wherein a plurality of insulating films are disposed between the active layer of the lower thin film transistor and the hydrogen-capture layer of the thin film transistor, and
wherein each of the plurality of insulating films comprises silicon nitride (SiN_{X}).

12. A display apparatus according to claim 1 wherein:
the thin film transistor is a first thin film transistor; and the display apparatus further comprises a second thin film transistor on the first thin film transistor,
and further wherein the active layer is a first active layer;
the first thin film transistor further comprises a first gate insulating film on the first active layer;
the gate electrode is a first gate electrode disposed on the first gate insulating film and overlapping the first active layer;
the interlayer insulating film is a first interlayer insulating film on the first gate electrode; and
the hydrogen capture layer is a lower hydrogen-capture layer on the first interlayer insulating film,
wherein the second thin film transistor comprises:
a second active layer;
a second gate insulating film on the second active layer;
a second gate electrode disposed on the second gate insulating film and overlapping the second active layer;
a second interlayer insulating film on the second gate electrode; and
an upper hydrogen capture layer on the second interlayer insulating film,
wherein the first interlayer insulating film includes a first flat surface parallel to an upper surface of the first gate electrode and a first-first inclined surface disposed on one side of the first flat surface and having a constant slope with respect to the first flat surface,
wherein the second interlayer insulating film includes a second flat surface parallel to an upper surface of the second gate electrode and a second-first inclined surface disposed on one side of the second flat surface and having a constant slope with respect to the second flat surface,
wherein the first gate insulating film exposes a part of the upper surface of the first active layer,
wherein the second gate insulating film covers an entire upper surface of the second active layer,
wherein the lower hydrogen capture layer includes a first-first hydrogen capture layer disposed on the first flat surface and a first-second hydrogen capture layer disposed on the first-first inclined surface, and
wherein the upper hydrogen capture layer includes a second-first hydrogen capture layer disposed on the second flat surface and a second-second hydrogen capture layer disposed on the second-first inclined surface,
wherein the first-first hydrogen-capture layer and the first-second hydrogen-capture layer have different crystal structures, and the second-first hydrogen-capture layer and the second-second hydrogen-capture layer have different crystal structures.

13. The display apparatus of claim 12, wherein a length of the first-first inclined surface is longer than a length of the second-first inclined surface, and a length of the first-second hydrogen capture layer is longer than a length of the second-second hydrogen capture layer; and optionally wherein
the first-second hydrogen capture layer does not overlap with the first gate insulating film, and the second-second hydrogen capture layer overlaps with the second gate insulating film.

14. A method for manufacturing a display apparatus, comprising:
forming an active layer;
sequentially forming a gate insulating film and a gate electrode on the active layer;
forming an interlayer insulating film on the gate electrode;
forming a hydrogen-capture pattern layer on the interlayer insulating film; and
heat-treating the hydrogen-capture pattern layer to form a hydrogen-capture layer,
wherein the interlayer insulating film includes a flat surface parallel to an upper surface of the gate electrode and a first inclined surface disposed on one side of the flat surface and having a constant slope with respect to the flat surface,
wherein the hydrogen-capture layer includes a first hydrogen-capture layer disposed on the flat surface and a second hydrogen-capture layer disposed on the first inclined surface, and
wherein the first hydrogen-capture layer and the second hydrogen-capture layer have different crystal structures.

15. The method for manufacturing a display apparatus of claim 14 further comprising manufacturing a display apparatus of any of claims 2 to 13; and optionally wherein
heat treating the hydrogen capture pattern layer is performed at a temperature of 300 to 400°C.
